# EUROPÄISCHE PATENTSCHRIFT

(11) **EP 0 806 429 B1**
(45) Veröffentlichungstag und Bekanntmachung des Hinweises auf die Patenterteilung: **19.12.2001**
(21) Anmeldenummer: 97250149.8
(22) Anmeldetag: 06.05.1997
(51) Int. Cl.: C07F 9/655, C08K 5/5313, C08L 63/00, C07F 9/6571, C08G 59/30, C08G 59/14

(54) **Flammfeste Expoxidharze und Flammschutzmittel für Epoxidharze**
Flame-retardant epoxy resins and flame retarders for epoxy resins
Résines époxy résistant aux flammes et agents ignifugeants pour résines époxy

(30) Priorität: 06.05.1996 DE 19619095
(43) Veröffentlichungstag der Anmeldung: 12.11.1997
(73) Patentinhaber: Schill & Seilacher "Struktol" Aktiengesellschaft, 22113 Hamburg (DE)
(72) Erfinder: Utz, Rainer, Dr., 21029 Hamburg (DE); Sprenger, Stephan, Dr., 22113 Oststeinbek (DE)
(74) Vertreter: UEXKÜLL & STOLBERG

(56) Entgegenhaltungen:
- EP-A- 0 646 587
- EP-A- 0 675 131
- DE-A- 2 652 007
- CHEMICAL ABSTRACTS, vol. 104, no. 26, 30. Juni 1986 Columbus, Ohio, US; abstract no. 225441, MATSUKAWA S ET AL: "Fire-resistant polyesters" XP002073999 & JP 60 248728 A (JAPAN ESTER CO., LTD.;JAPAN) 9. Dezember 1985
- CHEMICAL ABSTRACTS, vol. 104, no. 13, 31. März 1986 Columbus, Ohio, US; abstract no. 109953, ODA S ET AL: "Phosphorus-containing epoxy compounds" XP002074000 & JP 60 161993 A (SANKO CHEMICAL CO., LTD.;JAPAN) 23. August 1985

## Beschreibung

Die Erfindung betrifft Flammschutzmittel für Epoxidharze und daraus hergestellte Erzeugnisse sowie für Zusammensetzungen, die Epoxidverbindungen enthalten. Weiterhin betrifft die Erfindung neue Verbindungen und Zusammensetzungen, die für den genannten Einsatzzweck geeignet sind, sowie ein Verfahren zur Herstellung der Zusammensetzungen. Schließlich betrifft die Erfindung flammfeste Epoxidharze und deren Verwendung.

Epoxidharze bzw. Epoxidharzsysteme werden heutzutage in den unterschiedlichsten Anwendungsbereichen eingesetzt, da sie über ein breites, individuell anpaßbares Eigenschaftsspektrum verfügen, und nach der Aushärtung sehr gute mechanische und chemische Kennwerte aufweisen. So werden Epoxidharzsysteme in Lacken und Beschichtungen, in Verklebungen der unterschiedlichsten Materialien, in Form- und Vergußmassen, zur Herstellung von Verbundwerkstoffen (und deren Vorstufe, den Prepregs) sowie vielen weiteren Gebieten eingesetzt.

Bei einer Reihe dieser Anwendungen wird eine Schwerbrennbarkeit bzw. eine sogenannte flammhemmende oder Flammschutzausrüstung gefordert. Dies ist besonders bei Einsatzgebieten wie Verbundwerkstoffen (Composites) für den Flugzeugbau oder Leiterplatten und Bauteilen für Elektronik-Anwendungen der Fall, wird jedoch auch oft bei Beschichtungen, Verklebungen und Formmassen gefordert.

Es hat daher nicht an Versuchen gemangelt, diese Forderung zu erfüllen. Eine Übersicht über das breite Spektrum der Flammschutzausrüstung von Epoxidharzsystemen gibt u.a. "Chemistry and Uses of Fire Retardants" von J.W. Lyons, erschienen 1970 im Verlag Wiley & Sons, Inc. Dort wird der Einsatz von Aluminiumverbindungen, halogenierten Verbindungen, auch mit Antimonverbindungen als Synergisten, sowie die Verwendung von Phosphorverbindungen beschrieben. Eine Übersicht über neuere Entwicklungen enthält u.a. "Fire and Flame Retardant Polymers" von A. Yehaskel, Noyes Data Corp., New Jersey, USA, 1979 oder "International Plastics Flammability Handbook", 2. Auflage, erschienen 1990 im Carl Hanser Verlag, München.

Zur Anwendung kommen derzeit eine ganze Reihe verschiedener Flammschutzmittel wie etwa Aluminiumoxidhydrate, basische Aluminiumcarbonate, Magnesiumhydroxide, diverse Borate und Phosphate, die den Epoxidharzsystemen als nicht reaktives Additiv zugesetzt werden. Reaktive Systeme sind vor allem Halogenverbindungen, besonders bromierte Aromaten, die (oftmals unter Verwendung von Antimonverbindungen als Synergisten) vor oder während der Aushärtung chemisch in das dreidimensionale Netzwerk des Epoxidsystems eingebunden werden. Durch die Verwendung von reaktiven Flammschutzkomponenten wird die Beeinträchtigung der Produkteigenschaften im Vergleich zu nicht reaktiven Additiven deutlich verringert.

Die am häufigsten verwendeten Halogenverbindungen führen jedoch zu erheblichen Problemen bei der Entsorgung von ausgehärteten Produkten aus Epoxidharzsystemen. Außerdem können im Schwel- oder Brandfall toxikologisch außerordentlich bedenkliche Verbindungen entstehen. Dies führte zur Entwicklung einer Reihe von Phosphorverbindungen, welche reaktiv in die Epoxidharzmatrix eingebunden werden können.

Die DE 26 52 007 A1 offenbart phosphorhaltige Epoxidharze, Verfahren zu ihrer Herstellung und ihre Verwendung zur Flammfestausrüstung. Bei dem Herstellungsverfahren wird das Epoxidharz mit einem Phospholan umgesetzt.

Die DE 43 08 184 A1 offenbart Epoxidharzmischungen zur Herstellung von Prepregs und Verbundwerkstoffen, die ohne den Zusatz von externen Flammschutzmitteln schwer brennbare Formstoffe liefern. Die Epoxidharzmischungen enthalten neben einem aromatischen Polyamin als Härter ein phosphormodifiziertes Epoxidharz, welches aus Struktureinheiten aufgebaut ist, die sich ableiten (a) von Polyepoxidverbindungen mit mindestens zwei Epoxidgruppen pro Molekül und (b) von wenigstens einer Verbindung aus der Gruppe Phosphinsäuren, Phosphonsäuren, Pyrophosphonsäuren und Phosphonsäurehalbestern. Es wird näher ausgeführt, daß es sich bei den Phosphinsäuren um Dialkylphosphinsäuren, vorzugsweise mit 1-6 Kohlenstoffatomen im Alkylrest, Alkylarylphosphinsäuren oder Diarylphosphinsäuren handelt. Beispielhaft genannte Phosphinsäuren sind Dimethylphosphinsäure, Methylethylphosphinsäure, Diethylphosphinsäure, Dipropylphosphinsäure, Ethylphenylphosphinsäure und Diphenylphosphinsäure.

Die japanische Offenlegungsschrift JP 60 248 728 offenbart flammfeste Polyester, die durch Polykondensation von Ethylenglykolterephtalat mit *P*-Phenyl-Derivaten von 9,10-Dihydro-9-oxa-10-phosphaphenanthren-10-oxid hergestellt werden. Die *P*-Phenyl-Einheiten sind mit Gruppen substituiert, die mit Polyestern reagieren können.

Die japanische Offenlegungsschrift JP 60 161 993 betrifft Glycidylpropanoatderivate von Phosphanoxiden, Phosphinsäuren und Phosphonsäuren, sowie deren Verwendung als Stabilisator für organische Substanzen, insbesondere hochmolekulare organische Substanzen oder als Flammschutzmittel sowie als Grundeinheit hochmolekularer Verbindungen. Die Epoxygruppe soll die Gruppen -P(O)- und -C(O)- aktivieren. Eine chemische Einbindung einer Epoxygruppe in ein Harz wird nicht offenbart.

Die EP 0 646 587 A1 beschreibt von Phosphateinheiten abgeleitete Flammschutzmittel für Epoxidharze. Die EP 0 675 131 A1 offenbart von Phosphanoxiden abgeleitete Polyglycidylether sowie unter deren Verwendung hergestellte härtbare flammfeste Epoxidharzzusammensetzungen.

Auch die DE 43 08 187 A1 beschreibt Epoxidharzmischungen zur Herstellung von Prepregs und Verbundwerkstoffen, die ohne den Zusatz von externen Flammschutzmitteln schwer brennbare Formstoffe liefern. Diese Epoxidharzmischungen enthalten neben einem aromatischen Polyamin als Härter ein phosphormodifiziertes Epoxidharz, das aus Struktureinheiten aufgebaut ist, welche sich ableiten (a) von Polyepoxidverbindungen mit mindestens zwei Epoxidgruppen pro Molekül und (b) von Phosphinsäure- und/oder Phosphonsäureanhydriden.

In der DE 43 18 013 A1 sind fünfwertige Phosphor-Verbindungen beschrieben, die als Zwischenprodukt oder Flammschutzadditiv eingesetzt werden können. Diese vorbekannten Verbindungen haben eine wesentlich andere Struktur als die erfindungsgemäßen Flammschutzmittel.

Die DE 43 40 834 A1 betrifft phosphormodifizierte Epoxidharze, Verfahren zu ihrer Herstellung und ihre Verwendung. Die Epoxidharze enthalten Struktureinheiten, die sich ableiten (a) von Polyepoxidverbindungen mit mindestens zwei Epoxidgruppen pro Molekül und (b) von Pyrophosphonsäuren und/oder Phosphonsäurehalbestern.

Die DT 26 46 218 A1 betrifft nicht Epoxidharze, sondern flammfeste Polyester. Als Flammschutzmittel werden insbesondere Derivate des 9,10-Dihydro-9-oxa-10-phosphaphenanthren-10-oxids (nachfolgend als DOP bezeichnet) verwendet. Die Flammschutzmittel werden hergestellt, indem das DOP, welches gegebenenfalls am Benzolkern substituiert ist, mit einer ungesättigten Verbindung mit einer esterbildenden funktionellen Gruppe umgesetzt wird, oder durch Veresterung mit einem Diol oder einer Carbonsäure gleichzeitig oder nach der vorstehend genannten Reaktion. Die ungesättigte Verbindung wird vorzugsweise aus Dicarbonsäuren, wie Maleinsäure, Fumarsäure, Itaconsäure, Acrylsäure, Methacrylsäure, Mesaconsäure, Citraconsäure, Glutaconsäure etc., oder ihren Anhydriden und Estern ausgewählt. Besonders bevorzugt sind Itaconsäure oder niedere Alkylester oder das Anhydrid von Itaconsäure.

Forderungen, die an eine zeitgemäße Flammschutzausrüstung für Epoxidharzsysteme gestellt werden, sind u.a. keine Verschlechterung der mechanischen und chemischen Eigenschaften wie z.B. Festigkeit, Modul, Thermoformbeständigkeit, Beständigkeit gegen Lösungsmittel und aggressive Chemikalien. Eine Verschlechterung der elektrischen Eigenschaften ist jedoch genauso unerwünscht. Auch eine Verminderung der Haftung von Klebstoffen oder der Haftung an Geweben bei der Prepreg- oder Composite-Herstellung ist grundsätzlich auszuschließen. Auch dürfen Lagerstabilitäten von Einkomponentensystemen (z.B. Klebstoffe, Prepregs), die ja bereits einen Härter enthalten, nicht negativ beeinflußt werden.

Im Hinblick auf die genannten Anforderungen besteht ein Bedürfnis nach einer verbesserten Flammschutzausrüstung für Epoxidharzsysteme. Aufgabe der Erfindung ist es, neue Verbindungen und Zusammensetzungen zu schaffen, die für den genannten Einsatzzweck geeignet sind. Zur Aufgabe gehört auch die Schaffung eines Verfahrens zur Herstellung der neuen Zusammensetzungen. Weiterhin gehört zur Aufgabe, neben den neuen Verbindungen und Zusammensetzungen auch als solche bekannte Verbindungen für die Verwendung als Flammschutzmittel für Epoxidharzsysteme vorzuschlagen. Schließlich betrifft die Aufgabe neue, flammfeste Epoxidharze, deren Verwendung und daraus hergestellte Erzeugnisse. Die Aufgabe wird durch die in den unabhängigen Patentansprüchen bezeichneten Ausführungsformen der Erfindung gelöst. Besonders bevorzugte Ausführungsformen ergeben sich aus den abhängigen Patentansprüchen.

Ein besonderer Vorteil der erfindungsgemäßen Flammschutzausrüstung besteht in ihrer universellen Einsetzbarkeit, d.h. ihrer Verwendbarkeit in völlig unterschiedlichen Anwendungsgebieten wie Composites (Verbundwerkstoffe), Leiterplatten, Vergußmassen, Formstoffen, Verklebungen, Lacken, Beschichtungen usw. Übliche Standardhärter können in Kombination mit der erfindungsgemäßen Flammschutzausrüstung verwendet werden. Eine einwandfreie Mischbarkeit der erfindungsgemäßen Flammschutzmittel mit Epoxidharzsystemen ist gegeben, so daß die Flammschutzausrüstung den Erfordernissen der jeweiligen Anwendung angepaßt werden kann und eine optimale Verarbeitbarkeit gewährleistet ist.

In einer Vielzahl von Versuchen hat sich eine bestimmte Struktur von Phosphorverbindungen als besonders vorteilhaft herausgestellt, um die eingangs genannten Anforderungen zu erfüllen und die vorstehend genannten Vorteile zu erzielen. Die gemäß der Erfindung als Flammschutzmittel eingesetzten Verbindungen können direkt mit Epoxidharzen und epoxidfunktionellen Verbindungen vermischt und verarbeitet werden, wobei dann die chemische Einbindung der Phosphorverbindungen zum größten Teil bei der Aushärtung erfolgt. Ebenso können diese Phosphorverbindungen jedoch auch vorher ganz oder teilweise mit epoxidfunktionellen Verbindungen umgesetzt werden und anschließend in reiner oder abgemischter Form verarbeitet werden. Vorteilhaft sind dabei die bessere Mischbarkeit mit Epoxidharzen sowie die einfachere Handhabung. Aus diesen verschiedenen Möglichkeiten ergeben sich unterschiedliche Ausführungsformen der Erfindung.

Alle Ausführungsformen der Erfindung beruhen auf der Erkenntnis, daß bestimmte Derivate und Zusammensetzungen, die von der 4-Hydroxy-butan-1-phosphinsäure und/oder ihrem intramolekularen Ester abgeleitet sind, sich besonders gut für die Flammschutzausrüstung von Epoxidharzsystemen eignen. Die Derivate der 4-Hydroxy-butan-1-phosphinsäure und ihrer intramolekularen Ester haben die folgende Struktur:

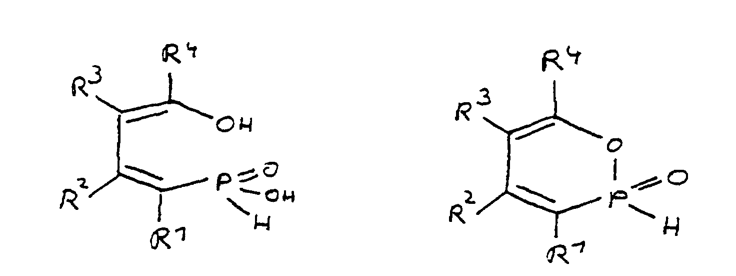

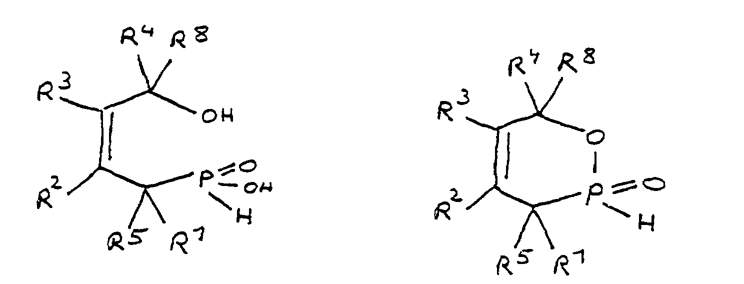

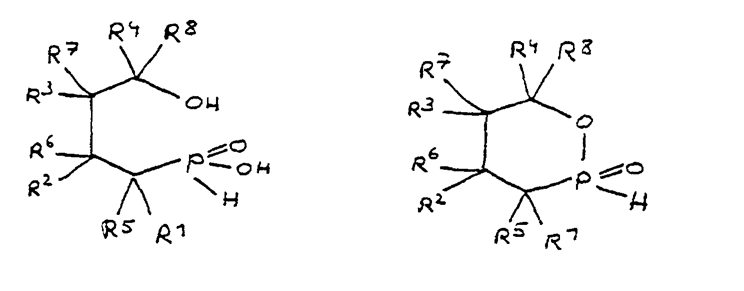

Die ringgeöffnete Säureform wird durch Abspaltung von Wasser in die cyclische Esterform überführt. Dabei steht die cyclische Esterform im Gleichgewicht mit der ringgeöffneten Säureform. Dieses Gleichgewicht kann thermisch beeinflußt werden. Sowohl die cyclische als auch die ringgeöffnete Form, als auch die Mischung beider, in jedem möglichen Verhältnis, können erfindungsgemäß zur Flammschutzausrüstung von Epoxidharzsystemen eingesetzt werden.

Bei den Resten R¹ bis R⁸ handelt es sich bevorzugt um Kohlenwasserstoffreste, die Bestandteil cyclischer, aliphatischer oder aromatischer Systeme sind. Insbesondere handelt es sich dabei um Fünf- oder Sechsringe. Auch heterocyclische und/oder mehrkernige Verbindungen können zur Erzielung der flammhemmenden Eigenschaften verwendet werden.

Ebenfalls Gegenstand der Erfindung ist die Herstellung von epoxyfunktionellen Verbindungen und ihr anschließender Einsatz in Epoxidharzsystemen zum Zwecke des Flammschutzes. Im einzelnen handelt es sich dabei um die Epoxyfunktionalisierung der genannten Phosphorverbindungen durch Umsetzungen mit
1) Epichlorhydrin und verwandten Verbindungen,
2) Bisphenol-A und Bisphenol-F Epoxidharzen sowie deren Mischungen, auch in höheren Molekulargewichten,
3) novolakbasierten Epoxidharzen sowie novolak-/kresolbasierten Epoxidharzen,
4) sogenannten Reaktivverdünnern, d.h. di- bis pentaepoxyfunktionellen aliphatischen, cycloaliphatischen oder aromatischen Verbindungen, und
5) N-Glycidylverbindungen aus aromatischen oder cycloaliphatischen Aminen oder Polyaminen sowie
6) Gemischen der in 1) bis 5) beschriebenen Verbindungen.

Gemäß dieser Ausführungsform werden die Epoxidverbindungen im Überschuß mit der ringgeöffneten und/oder ringgeschlossenen Phosphorverbindung umgesetzt, so daß als Produkt eine epoxyfunktionelle, phosphorhaltige Verbindung entsteht.

Es muß jedoch keineswegs immer eine vollständige, hundertprozentige Umsetzung zu einer epoxyfunktionellen Verbindung durchgeführt werden. Vielmehr kann es sinnvoll sein, nur eine teilweise Umsetzung durchzuführen, wobei als Produkt dann die jeweilige ringgeöffnete oder ringgeschlossene Phosphorverbindung in Mischung mit der epoxyfunktionalisierten Phosphorverbindung sowie nicht umgesetztem Reagenz, z.B. einem Bisphenol-A-Harz, vorliegt.

Ebenso können Mischungen von ringgeöffneter und ringgeschlossener Phosphorverbindung, ihre epoxyfunktionalisierten Umsetzungsprodukte und nicht umgesetztem Reagenz vorliegen. Auch können mehrere Reagenzien verwendet werden, ebenso können den reinen Umsetzungsprodukten oder den oben beschriebenen Mischungen weitere Additive hinzugefügt werden, so z.B. Reaktivverdünner zur Einstellung einer bestimmten Viskosität oder Tenside als Benetzungshilfen.

Ebenfalls Gegenstand der Erfindung ist die Herstellung oder Verwendung von Zwischenprodukten, die aus den vorher beschriebenen phosphorhaltigen Verbindungen hergestellt werden, zur flammhemmenden Ausrüstung von Epoxidharzen. Dies kann von Vorteil sein, wenn die weitere Umsetzung mit einer epoxyfunktionellen Verbindung, wie z.B. einem Bisphenol-A-Harz, exakt gesteuert werden soll.

Gemäß einer Ausführungsform betrifft die Erfindung neue, epoxyfunktionelle Derivate der 4-Hydroxy-butan-1-phosphinsäure bzw. ihres intramolekularen Esters entsprechend folgenden Formeln: 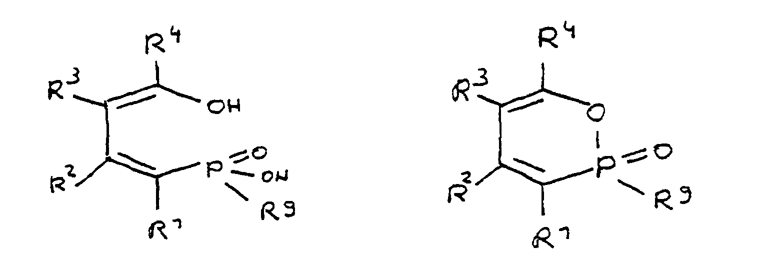 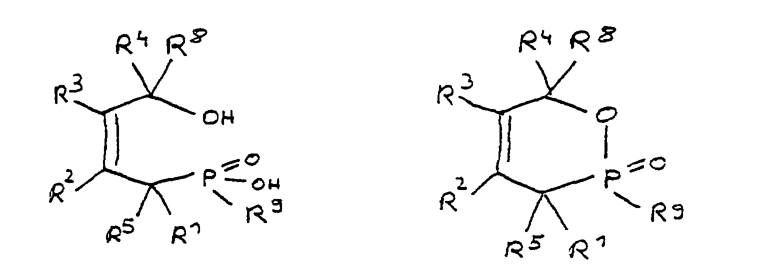 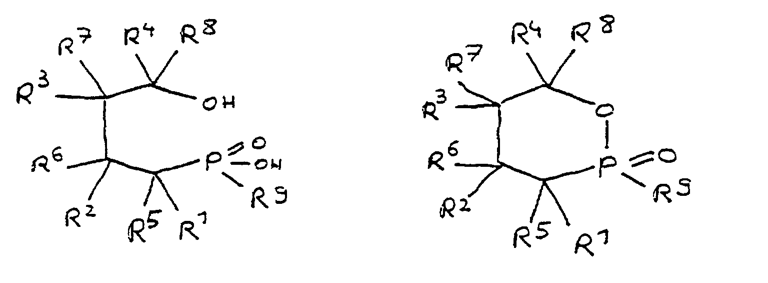 in denen R¹ bis R⁸ unabhängig voneinander Wasserstoff oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, mit der Maßgabe, daß höchstens drei der Reste R¹ bis R⁴ Wasserstoff sind, und zwei oder mehr der Reste R¹ bis R⁸ unter Ausbildung von Cyclen verknüpft sein können, und
R⁹ eine Gruppe ist, die mindestens eine Epoxyfunktion aufweist, wobei R⁹
(i) eine aliphatische, alicyclische oder aromatische Kohlenwasserstoffgruppe ist, die mindestens eine Epoxyfunktion aufweist, oder
(ii) eine Alkylaryl- oder Arylalkylgruppe ist, die mindestens eine Epoxyfunktion aufweist, oder
(iii) von dem Addukt aus Bisphenol A und Epichlorhydrin abgeleitet ist und der Formel 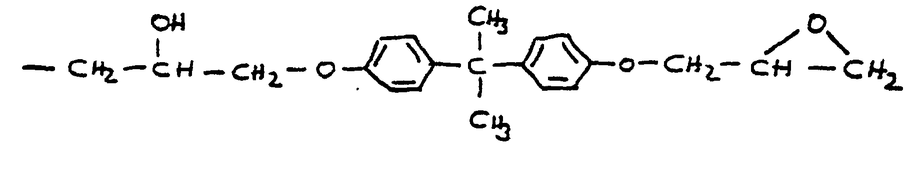 entspricht, oder
(iv) von dem Addukt aus Bisphenol F und Epichlorhydrin abgeleitet ist, oder
(v) von novolakbasierten Epoxidharzen und/oder novolak-/kresolbasierten Epoxidharzen abgeleitet ist, oder
(vi) von Reaktiwerdünnern abgeleitet ist, welche mindestens eine Verbindung ausgewählt aus di- bis pentaepoxidfunktionellen aliphatischen, cycloaliphatischen oder aromatischen Verbindungen enthalten, oder
(vii) von N-Glycidylverbindungen aus aromatischen oder cycloaliphatischen Aminen oder Polyaminen abgeleitet ist.

Das erfindungsgemäße epoxyfunktionelle Derivat hat vorzugsweise einen Phosphorgehalt von 2 bis 16 Gew.-%. Bei diesem Phosphorgehalt stellt das Derivat ein besonders wirksames Flammschutzmittel dar. Der Phosphorgehalt läßt sich durch geeignete Auswahl der Reste R¹ bis R⁸ innerhalb des genannten Bereiches einstellen. Je größer z.B. die Gesamtzahl der Kohlenstoffatome in den Resten R¹ bis R⁸ ist, umso kleiner ist der relative Beitrag des Phosphors aus der Phosphinsäuregruppe zum Molekulargewicht. Andererseits kann der Phosphorgehalt dadurch erhöht werden, daß einer der Reste R¹ bis R⁸ Phosphor als Heteroatom enthält. Der Phosphorgehalt soll insbesondere 2 bis 10 Gew.-% und am meisten bevorzugt 3 bis 8 Gew.-% betragen.

Vorzugsweise enthalten R¹ bis R⁸ zusammen 6 bis 100 Kohlenstoffatome.

Diese neuen Verbindungen eignen sich hervorragend für den Einsatz als Flammschützmittel für Epoxidharzsysteme. Aufgrund ihrer Struktur sind sie auch sehr gut verarbeitbar und insbesondere mit Epoxidharzen gut mischbar.

Ein erfindungsgemäß besonders bevorzugtes Derivat der 4-Hydroxybutan-1-phosphinsäure bzw. ihres intramolekularen Esters ist dadurch gekennzeichnet, daß die Esterform folgender Formel entspricht: 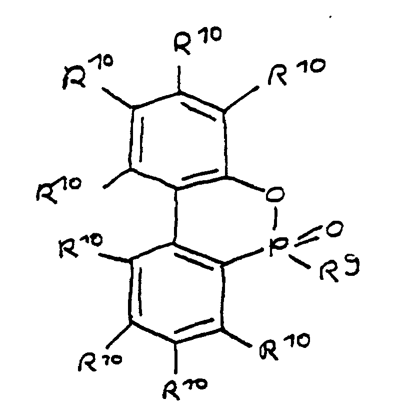 in der R⁹ die angegebene Bedeutung hat und
die Reste R¹⁰ unabhängig voneinander Wasserstoff, Halogen oder eine Kohlenwasserstoffgruppe sind, die gegebenenfalls ein oder mehrere Heteroatome ausgewählt aus Sauerstoff, Stickstoff, Schwefel, Phosphor, Silicium und Halogen enthält, wobei zwei oder mehr der Reste R¹⁰ unter Ausbildung von Cyclen verknüpft sein können.

Wenn in dieser Formel alle Reste R¹⁰ Wasserstoff sind, dann handelt es sich bei den neuen Verbindungen um epoxyfunktionelle Derivate des 9,10-Dihydro-9-oxa-10-phoshaphenanthren-10-oxids (DOP). Zwar sind esterfunktionelle Derivate von DOP im Stand der Technik als Flammschutzmittel für Polyesterfasern bekannt. Die Herstellung von epoxyfunktionellen Derivaten von DOP ist jedoch bislang nicht in Betracht gezogen worden.

Entscheidend ist also, daß bei den neuen Derivaten der 4-Hydroxy-butan-1-phosphinsäure bzw. ihres intramolekularen Esters der Rest R⁹ mindestens eine Epoxyfunktion aufweist. Grundsätzlich kommen beliebige Reste in Betracht, die mindestens eine Epoxyfunktion aufweisen. Die Reste R⁹ können auf aliphatischen, alicyclischen oder aromatischen Kohlenwasserstoffen basieren, wobei auch Kombinationen wie Alkylaryl- oder Arylalkylreste in Betracht zu ziehen sind. Vorzugsweise ist der Rest R⁹ von Epichlorhydrin oder dem Addukt aus Bisphenol A und Epichlorhydrin abgeleitet. In diesen Fällen entspricht R⁹ folgenden Formeln:

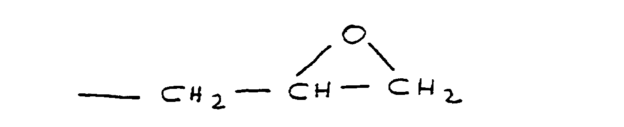

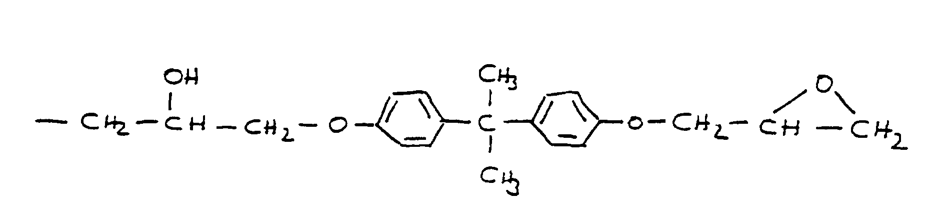

Der Rest R⁹ kann auch von dem Addukt aus Bisphenol F und Epichlorhydrin abgeleitet sein. Es kommt auch ein Addukt in Betracht, daß von einer Mischung aus Bisphenol-A und Bisphenol-F sowie Epichlorhydrin abgeleitet ist.

Neben den vorstehend genannten neuen Verbindungen betrifft die Erfindung auch neue Zusammensetzungen mit flammhemmenden Eigenschaften sowie ein Verfahren zur Herstellung der Zusammensetzungen. Das Herstellungsverfahren ist dadurch gekennzeichnet, daß man
a) mindestens ein Derivat der 4-Hydroxy-butan-1-phosphinsäure und/oder ihres intramolekularen Esters entsprechend folgenden Formeln: 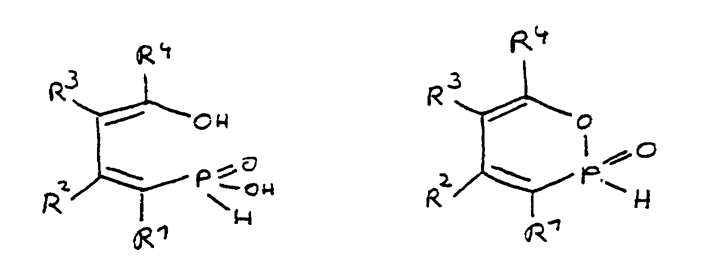 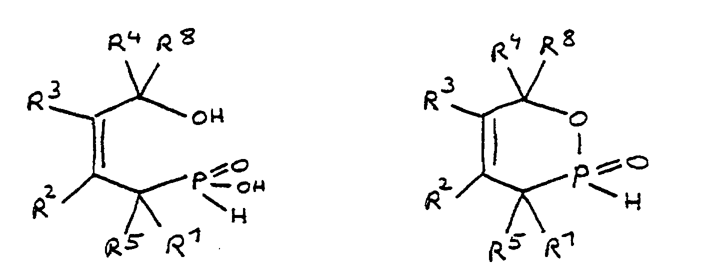 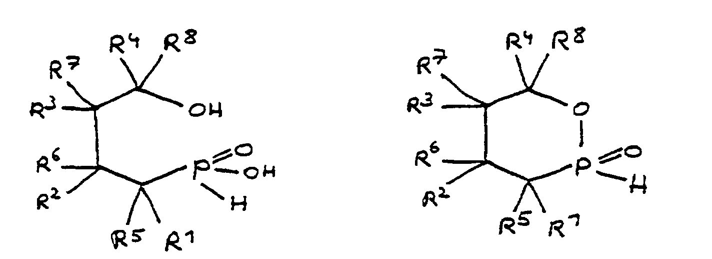 in denen R¹ bis R⁸ die oben angegebene Bedeutung haben, mit
b) mindestens einer Komponente umsetzt, die im Molekül mindestens eine Epoxidgruppe aufweist und in der Lage ist, mit der Phosphingruppe des Derivats a) unter Ausbildung einer Phosphor-Kohlenstoff-Bindung zu reagieren,
wobei die als Reaktionsprodukt erhaltene Zusammensetzung reaktive Epoxidgruppen aufweist.

Als Komponente a) wird vorzugsweise ein Derivat mit einem Phosphorgehalt von 4 bis 29 Gew.-%, insbesondere 5 bis 12 Gew.-%, am meisten bevorzugt 6 bis 10 Gew.-% verwendet.

Weiterhin ist es erwünscht, daß die als Reaktionsprodukt erhaltene Zusammensetzung einen Phosphorgehalt von 2 bis 16 Gew.-% aufweist.

Vorzugsweise wird als Komponente a) ein Derivat verwendet, bei dem die Reste R¹ bis R⁸ zusammen 6 bis 100 Kohlenstoffatome enthalten.

Man geht also von einer monofunktionellen Phosphinsäure bzw. ihrem intramolekularen Ester aus, welche die Komponente a) darstellt. Diese Komponente a) wird mit einer weiteren Komponente b) umgesetzt, die in der Lage ist, mit der Phosphingruppe der Komponente a) unter Ausbildung einer Phosphor-Kohlenstoffbindung zu reagieren. Das Reaktionsprodukt ist dann eine difunktionelle Phosphinsäure bzw. deren intramolekularer Ester. Die Komponente b) weist im Molekül mindestens eine Epoxidgruppe auf. Das Reaktionsprodukt ist also ein epoxyfunktionelles Derivat der Phosphinsäure oder ihres intramolekularen Esters. Wie oben bereits angesprochen, ist es keineswegs immer erforderlich, eine vollständige, hundertprozentige Umsetzung zu der epoxyfunktionellen Verbindung durchzuführen. Die Erfindung erstreckt sich auch auf Zusammensetzungen, welche durch eine teilweise Umsetzung erhalten werden. Solche Zusammensetzungen können beispielsweise als Produkt die jeweilige ringgeöffnete oder ringgeschlossene Phosphorverbindung in Mischung mit der epoxyfunktionalisierten Phosphorverbindung sowie dem nicht umgesetzten Reagenz, z.B. ein Bisphenol-A-Harz, enthalten. In dem Produkt können auch die ringgeöffnete und die ringgeschlossene Phosphorverbindung sowohl in monosubstituierter als auch in disubstituierter Form vorliegen.

Es ist erfindungsgemäß bevorzugt, daß man bei dem Verfahren zur Herstellung der Zusammensetzung ein Derivat der 4-Hydroxy-butan-1-phosphinsäure bzw. ihres intramolekularen Esters verwendet, dessen Esterform folgender Formel entspricht: 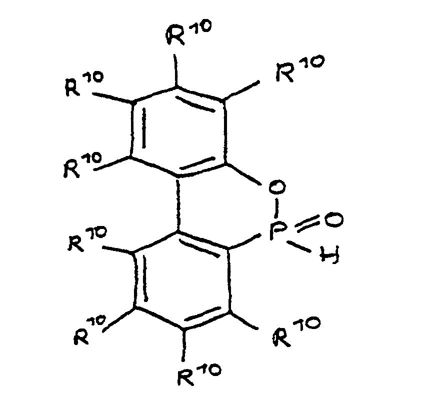 in der die Reste R¹⁰ die oben angegebene Bedeutung haben.

Als Komponente b) werden bei dem Verfahren vorzugsweise folgende Materialien verwendet:
Epichlorhydrin,
das Addukt aus Bisphenol-A und/oder Bisphenol F und Epichlorhydrin,
in Novolak basierte Epoxidharze und/oder novolak-/kresolbasierte Epoxidharze,
Reaktivverdünner, welche mindestens eine Verbindung ausgewählt aus di- bis pentaepoxyfunktionellen aliphatischen, cycloaliphatischen oder aromatischen Verbindungen enthalten, oder
N-Glycidylverbindungen aus aromatischen oder cycloaliphatischen Aminen bzw. Polyaminen sowie
Gemische der vorstehend beschriebenen Verbindungen.

Die Erfindung bezieht sich auf das vorstehend beschriebene Herstellungsverfahren sowie auf die Zusammensetzungen, die gemäß diesem Verfahren erhältlich sind. Weiterhin betrifft die Erfindung die Verwendung dieser Zusammensetzungen als Flammschutzmittel für Epoxidharze in unvernetzter, teilweise vernetzter oder vernetzter Form, für unter Verwendung von Epoxidharzen hergestellte Erzeugnisse, und für Zusammensetzungen, die niedermolekulare Epoxidverbindungen enthalten und aus diesen bestehen, wie insbesondere Reaktivverdünner.

Gemäß einer weiteren Ausführungsform betrifft die Erfindung die Verwendung von Derivaten der 4-Hydroxy-butan-1-phosphinsäure und/oder ihres intramolekularen Esters entsprechend folgenden Formeln: 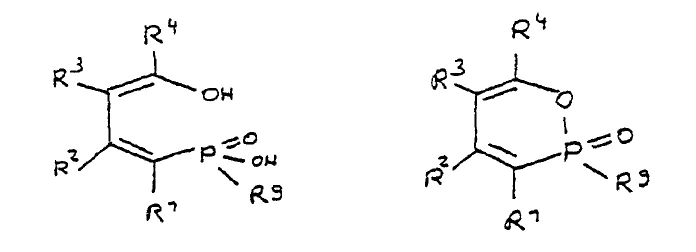 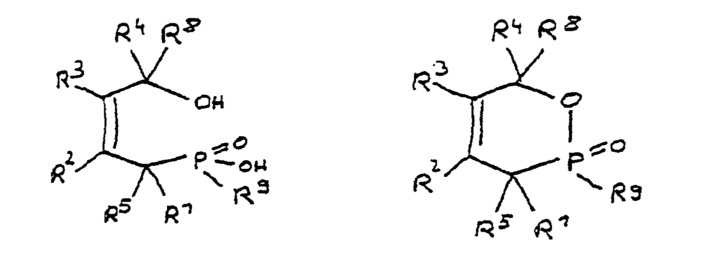 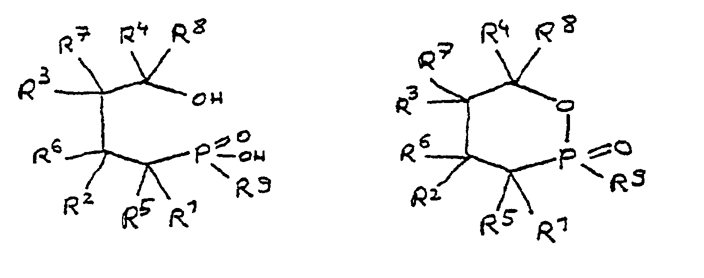 in denen R¹ bis R⁸ die oben angegebene Bedeutung haben und
- R⁹: Wasserstoff ist oder
- R⁹: eine Gruppe ist, die mindestens eine Epoxyfunktion aufweist, wobei R⁹
(i) eine aliphatische, alicyclische oder aromatische Kohlenwasserstoffgruppe ist, die mindestens eine Epoxyfunktion aufweist, oder
(ii) eine Alkylaryl- oder Arylalkylgruppe ist, die mindestens eine Epoxyfunktion aufweist, oder
(iii) von dem Addukt aus Bisphenol A und Epichlorhydrin abgeleitet ist und der Formel 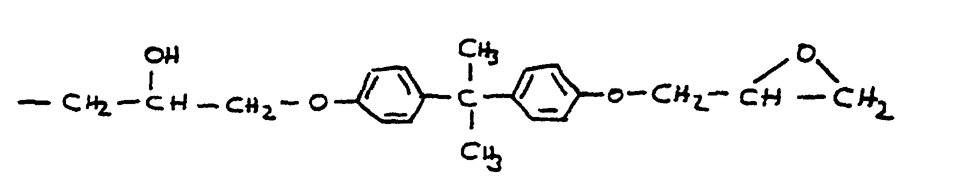 entspricht, oder
(iv) von dem Addukt aus Bisphenol F und Epichlorhydrin abgeleitet ist, oder
(v) von novolakbasierten Epoxidharzen und/oder novolak-/kresolbasierten Epoxidharzen abgeleitet ist, oder
(vi) von Reaktivverdünnern abgeleitet ist, welche mindestens eine Verbindung ausgewählt aus di- bis pentaepoxidfunktionellen aliphatischen, cycloaliphatischen oder aromatischen Verbindungen enthalten, oder
(vii) von N-Glycidylverbindungen aus aromatischen oder cycloaliphatischen Aminen oder Polyaminen abgeleitet ist,
als Flammschutzmittel für Epoxidharze in unvernetzter, teilweise vernetzter oder vernetzter Form, unter Verwendung von Epoxidharzen hergestellte Erzeugnisse, und Zusammensetzungen, die niedermolekulare Epoxidharzverbindungen enthalten oder aus diesen bestehen, insbesondere Reaktivverdünner.

Das erfindungsgemäß verwendete Derivat hat vorzugsweise einen Phosphorgehalt von 2 bis 16 Gew.-%, insbesondere von 2 bis 10 Gew.-% und am meisten bevorzugt von 3 bis 8 Gew.-%.

Vorzugsweise wird ein Derivat verwendet, bei dem die Reste R¹ bis R⁸ zusammen 6 bis 100 Kohlenstoffatome enthalten.

Besonders bevorzugt ist die Verwendung eines Derivats der 4-Hydroxy-butan-1-Phosphinsäure bzw. ihres intramolekularen Esters, bei dem die Esterform der folgenden Formel entspricht: 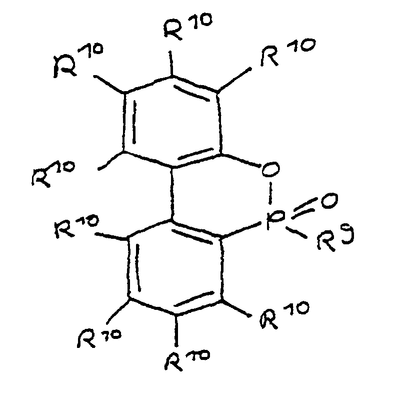 in der R⁹ und R¹⁰ die oben angegebene Bedeutung haben.

Gemäß der Erfindung können also als Flammschutzmittel für Epoxidharzsysteme neben den oben beschriebenen neuen Verbindungen und Zusammensetzungen auch bestimmte ausgewählte Verbindungen verwendet werden, die als solche im Stand der Technik bereits bekannt sind. Ein Beispiele für solche bereits bekannte Verbindungen, die erfindungsgemäß verwendet werden können, ist DOP.

Die erfindungsgemäße Verwendung umfaßt insbesondere die folgenden Alternativen:
- Verwendung der monofunktionellen Phosphinsäure und/oder ihres intramolekularen Esters als Flammschutzmittel. In diesem Fall wird beispielsweise die monofunktionelle Verbindung mit einem oligomeren Epoxidharz vermischt. Die Phosphinsäuregruppe kann mit einer der Epoxidgruppen des Epoxidharzes reagieren. Die Umsetzung kann teilweise oder vollständig erfolgen, wodurch mindestens ein Teil des Flammschutzmittels chemisch an das Epoxidharz gebunden wird.
- Die monofunktionelle Phosphinsäure und/oder ihr intramolekularer Ester werden zunächst in ein Zwischenprodukt überführt, welches eine difunktionelle Phosphinsäure und/oder deren intramolekularer Ester ist. Dieses Zwischenprodukt weist eine zusätzliche funktionelle Gruppe, und zwar eine Epoxidfunktion, auf, welche in der Lage ist, mit einem der anderen Bestandteile des Epoxidharzsystems, insbesondere einem oligomeren Epoxidharz, zu reagieren. Der Einsatz derartiger Zwischenprodukte kann vorteilhaft sein, weshalb diese Ausführungsform erfindungsgemäß bevorzugt ist.

Bei der erfindungsgemäßen Verwendung geht man insbesondere so vor, daß man das Flammschutzmittel mit dem unvernetzten oder teilweise vernetzten Epoxidharz vermischt, mindestens einen Härter zusetzt und die so erhaltene Zusammensetzung unter Aushärten in das gewünschte Erzeugnis überführt.

Gemäß einer weiteren Ausführungsform betrifft die Erfindung flammfeste Epoxidharze. Sie erstreckt sich sowohl auf unvernetzte oder teilweise vernetzte flammfeste Epoxidharze als auch auf die unter Vernetzung und Aushärtung erhaltenen flammfesten Epoxidharz-Erzeugnisse. Die flammfesten Epoxidharze können unter Verwendung des erfindungsgemäßen Flammschutzmittels hergestellt werden.

Das erfindungsgemäße flammfeste Expoxidharz enthält vorzugsweise 2 bis 7 Gew.-% Phosphor in der Harzmasse. Dabei ist unter "Harzmasse" nur das Gesamtgewicht von eingesetztem Epoxidharz und Flammschutzmittel zu verstehen. Weitere gegebenenfalls eingesetzte Komponenten wie Härter, Füllstoff oder Glasfasermatte bleiben bei der Bestimmung des Phosphorgehaltes außer Betracht. Ein Vorteil der erfindungsgemäßen flammfesten Epoxidharze ist darin zu sehen, daß sie unter Verwendung eines reaktiven Flammschutzmittels hergestellt worden sind. Mindestens ein Teil des reaktiven Flammschutzmittels reagiert mit dem Epoxidharz und/oder dem gegebenenfalls eingesetzten Härter. Es ist erfindungsgemäß bevorzugt, daß mindestens 50 Gew.% des Phosphorgehaltes chemisch in das Epoxidharz eingebunden sind.

Andererseits kann man das erfindungsgemäße flammfeste Epoxidharz auch unmittelbar über ein Strukturmerkmal definieren. Das Epoxidharz ist dadurch gekennzeichnet, daß es als Teil seiner unvernetzten, teilweise vernetzten oder vernetzten Struktur Einheiten aufweist, die von der 4-Hydroxy-butan-1-phosphinsäure und/oder ihrem intramolekularen Ester abgeleitet und über deren Phosphoratom gebunden sind, wobei die Einheiten folgenden Formeln 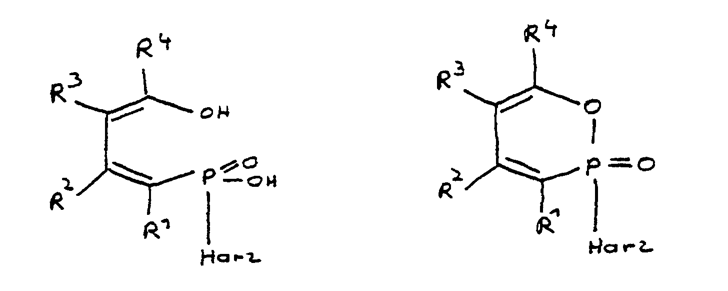 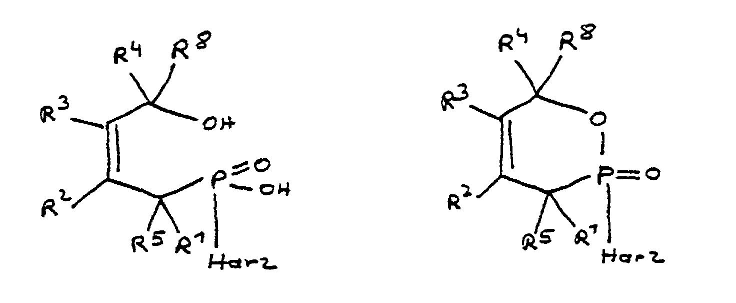 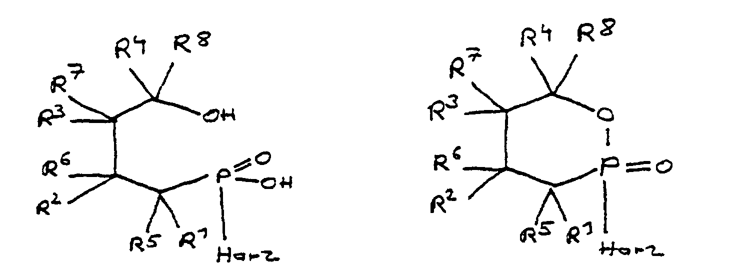 entsprechen, in denen R¹ bis R⁸ unabhängig voneinander Wasserstoff oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, wobei zwei oder mehr der Reste R¹ bis R⁸ unter Ausbildung von Cyclen verknüpft sein können.

Es ist erwünscht, daß in den Einheiten höchstens drei der Reste R¹ bis R⁴ Wasserstoff sind. Insbesondere enthalten die Reste R¹ bis R⁸ zusammen 6 bis 100 Kohlenstoffatome.

Auch hier ist es bevorzugt, daß das Epoxidharz 2 bis 7 Gew.-% Phosphor in der Harzmasse enthält, wobei unter Harzmasse das Gesamtgewicht von eingesetztem Harz und Flammschutzmittel ohne Berücksichtigung weiterer Komponenten wie Härter, Füllstoff oder Glasfasermatte zu verstehen ist.

Gemäß einer besonders bevorzugten Ausführungsform ist das flammfeste Epoxidharz dadurch gekennzeichnet, daß es Einheiten aufweist, die von der 4-Hydroxy-butan-1-phoshinsäure und/oder ihrem intramolekularem Ester abgeleitet sind, wobei die Esterform der Einheiten folgender Formel enspricht 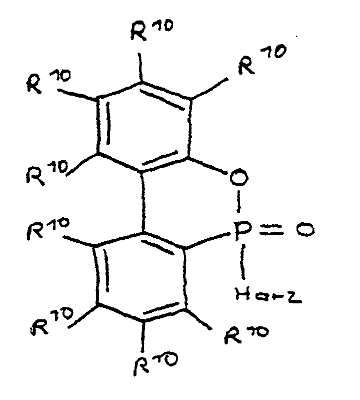 in der die Reste R¹⁰ die oben angegebene Bedeutung haben.

Alle Ausführungsformen der Erfindung betreffen Derivate der 4-Hydroxy-butan-1-phosphinsäure und/oder ihres intramolekularen Esters, wobei in allen Formeln jeweils identisch die Reste R¹ bis R⁸ vorhanden sind, die unabhängig voneinander Wasserstoff oder eine Kohlenwasserstoffgruppe bedeuten. Bei den Kohlenwasserstoffen kann es sich um lineare oder verzweigte Alkylgruppen, Cycloalkylgruppen, Arylgruppen, Alkylarylgruppen oder Arylalkylgruppen handeln, wobei auch Kombinationen der vorstehend genannten Möglichkeiten in Betracht zu ziehen sind. Die Kohlenwasserstoffgruppen können untereinander zu gesättigten und ungesättigten Cyclen verknüpft sein, wobei Fünfringe und Sechsringe bevorzugt sind. Besonders bevorzugt ist die Verknüpfung zu Benzolkernen unter Einbezug des Grundgerüstes. Die Reste R⁵ bis R⁸ sind, falls sie vorhanden sind, normalerweise Wasserstoff.

Die Erfindung betrifft auch die Verwendung der flammfesten Epoxidharze zur Herstellung von Überzügen und Formkörpern. Weiterhin betrifft die Erfindung Erzeugnisse, die unter der Verwendung der flammfesten Epoxidharze hergestellt worden sind. Als Beispiele für derartige Erzeugnisse seien genannt:
- Prepregs und Verbundstoffe auf der Basis von anorganischen oder organischen Verstärkungsmaterialien in Form von Fasern, Vliesen oder Geweben, oder von Flächenstoffen;
- Leiterplatten, hergestellt aus Glasfasergewebe und Epoxidharzmischungen;
- Formkörper aller Art; und
- Erzeugnisse mit Überzügen aus Epoxidharz.

Für die flammfeste Ausrüstung von Epoxidharzen, die im Elektronikbereich eingesetzt werden, eignet sich besonders gut die ringgeschlossene Form, d.h. die Derivate des intramolekularen Esters der 4-Hydroxy-butan-1-phosphinsäure.

Am meisten bevorzugt werden für diesen Einsatzbereich Flammschutzmittel, die sich von der ringgeschlossenen Form des DOP ableiten.

Im folgenden wird die Erfindung anhand von Beispielen näher erläutert. Die Prüfmethoden und Normen, nach denen die Schwerentflammbarkeit geprüft wurde, sind beschrieben in: "International Plastics Flammability Handbook", 2. Auflage, von Jürgen Troitzsch, erschienen im Carl Hanser Verlag, München, Wien, New York, 1990.

### Beispiel 1)

Herstellung einer Mischung einer ringgeöffneten Phosphorverbindung mit einem Epoxidharz:

Als Phosphorverbindung wurde 9,10-Dihydro-9-oxa-10-phospanthren-10-oxid in der ringgeöffneten Form eingesetzt (Schmelzpunkt ca. 95°C), hier als DOP 95 bezeichnet.

Es wurden 600 g eines Bisphenol-A-Standardharzes in einem Vierhalskolben mit Rührer, Rückflußkühler und Thermofühler vorgelegt und auf 60°C erwärmt. Dann wurden 400 g DOP 95 in mehreren Portionen zugegeben und eingearbeitet. Es wurde eine weitere Stunde bei 60°C gerührt. Das Produkt war ein weißes, viskoses Gemisch mit einem Epoxyäquivalentgewicht von 308 (EEW des Standardharzes 185).

Nach Aushärtung mit der stöchiometrischen Menge Methylhexahydrophthalsäureanhydrid (MHHPSA) für zwei Stunden bei 140°C erfüllt eine solche Gußmasse V0 nach UL94 (Prüfnorm der Underwriter Laboratories, beschrieben s.o.).

Im zweiten Falle wurde statt 600 g Standardharz 500 g Standardharz und 100 g des Diglycidylethers des Hexandiols (ein sog. Reaktivverdünner) verwendet. Die Viskosität des erhaltenen Gemisches liegt dabei deutlich tiefer als im ersten Fall und erleichtert damit die Verarbeitbarkeit. Das EEW wurde zu 280 bestimmt. Nach Aushärtung mit MHHPSA erfüllt auch diese Mischung V0 nach UL 94.

### Beispiel 2)

Umsetzung einer ringgeöffneten Phosphorverbindung mit einem Epoxidharz:

In einem Vierhalskolben mit Rührer, Rückflußkühler und Temperaturfühler wurden 600 g eines Bisphenol-A-Standardharzes vorgelegt und auf 120°C erwärmt. Dann erfolgte die portionsweise Zugabe von 400 g DOP 95. Dieses schmolz beim Kontakt mit dem Harz. Unter Erwärmung auf 160°C fand die Reaktion statt. Durch Rühren für weitere zwei Stunden bei 160°C wurde die Reaktion vervollständigt. Das Produkt war ein klares Festharz mit einem Epoxyäquivalentgewicht von 830.

Nach Aushärtung mit der stöchiometrischen Menge MHHPSA (2 Stunden bei 140°C) erfüllte das Harz im Test V0 nach UL 94.

### Beispiel 3)

Herstellung einer Mischung einer ringgeschlossenen Phosphorverbindung mit einem Bisphenol-A-Standardharz:

In einem Vierhalskolben mit Rückflußkühler, Rührer und Temperaturfühler wurden 600 g eines Bisphenol-A-Standardharzes (EEW 185) bei 80°C vorgelegt. In einem darüber angebrachten Reaktionskolben (mit Sumpfabfluß) wurden 400 g DOP 95 zunächst aufgeschmolzen. Dann wurde auf 160°C erhitzt und Vakuum angelegt. Dabei entsteht unter Wasserabspaltung die ringgeschlossene Form der Phosphorverbindung, sie sei hier DOP 118 genannt. Das entstehende Wasser wurde abdestilliert, anschließend auf 120°C abgekühlt. Dann wurde das noch flüssige DOP 118 langsam unter Rühren zum Harz zugetropft. Eine Stunde Nachrühren zur Homogenisierung. Nach dem Abkühlen lag eine weiße, sehr viskose Mischung vor. Das Epoxyäquivalentgewicht wurde zu 205 bestimmt.

Nach Aushärtung mit der stöchiometrischen Menge MHHPSA (2 Stunden bei 140°C) erfüllte der Gießkörper V0 nach UL 94.

### Beispiel 4)

Umsetzung einer ringgeschlossenen Phosphorverbindung mit einem Bisphenol-A-Standardharz:

Es wurde wie in Beispiel 3) verfahren, jedoch mit folgenden Unterschieden: Die Temperatur des Bisphenol-A-Standardharzes betrug 160°C, außerdem wurden 0,04% eines Katalysators zur Steuerung der Reaktion zugesetzt. Nachdem die gesamte Menge an DOP 118 portionsweise zugegeben wurde, wurde noch für weitere zwei Stunden bei 160°C gerührt, um eine komplette Umsetzung zu erhalten. Nach dem Abkühlen lag ein festes, transparentes Harz vor. Das Epoxyäquivalentgewicht wurde zu 720 bestimmt, der Erweichungspunkt lag bei 79°C.

Das Harz wurde mit den entsprechenden stöchiometrischen Mengen von a) MHHPSA, b) Triethylentetramin und c) Dicyandiamid jeweils 2 Stunden bei 140°C (im Falle c) bei 170°C) ausgehärtet. Alle Gießkörper erfüllten unabhängig vom Härtertyp und der Härtermenge V0 nach UL 94.

### Beispiel 5

Umsetzung einer ringgeschlossenen Phosphorverbindung mit einem Novolak-Epoxidharz, gelöst in MEK:

In einem Vierhalskolben mit Rückflußkühler, Rührer und Temperaturfühler wurden 600 g eines Novolak-Epoxidharzes (EEW:180), 80%ig in Methylethylketon gelöst, vorgelegt. Nach Aufheizen auf 105°C wurden 0,04% eines Katalysators zugegeben. Das flüssige DOP 118 wurde wie im Beispiel 3) beschrieben unter Rühren langsam zugetropft. Nach beendeter Zugabe wurden weitere 4 Stunden unter leichtem Rückfluß gerührt (bei 105°C).

Das entstandene, hochviskose, leicht trübe Produkt wies einen Festgehalt von 86%, ein EEW von 720 und eine dynamische Viskosität (25°C) von 800 Pa*s auf.

Mit der stöchiometrischen Menge an MHHPSA wurden Probenkörper hergestellt, wobei zum Abzug des Lösungsmittels stufenweise ausgehärtet wurde: 2 Stunden bei 60°C, 2 Stunden bei 90°C, 2 Stunden bei 140°C. Die Probekörper erfüllten V0 nach UL94.

### Beispiel 6

Umsetzung einer ringgeschlossenen Phosphorverbindung mit einer Mischung eines Bisphenol-A-Standardharzes und eines Reaktivverdünners:

Es wurde verfahren wie in Beispiel 4), jedoch wurde eine 1:1 Mischung von DGEBA und dem Triglycidylether des Trimethylolpropans anstelle des Standardharzes eingesetzt. Das Produkt ist ein klares Festharz mit einem Erweichungspunkt von 51°C und einem EEW von 440.

### Beispiel 7)

Umsetzung einer ringgeschlossenen Phosphorverbindung mit Epichlorhydrin:

400 g DOP 118, 860 g Epichlorhydrin und eine katalytische Menge Tetrabutylammoniumchlorid (als 50%ige Lösung in Wasser), wurden in einem Dreihalskolben mit Rührer, Tropftrichter mit Druckausgleichrohr und Rückflußkühler mit Wasserabscheider und einem Thermometer, vorgelegt. Nachdem die gesamte Apparatur auf ein Vakuum von ca. 150 mbar eingestellt war, wurde das Reaktionsgemisch unter Rühren auf ca. 60°C aufgeheizt, bis das Epichlorhydrin zu sieden begann. Nachdem der Wasserabscheider mit Epichlorhydrin gefüllt war, wurde begonnen, eine 50%ige wäßrige NaOH-Lösung (2 mol) über den Tropftricher so einzutragen, daß das eingebrachte Wasser sofort azeotrop abdestilliert. Anschließend wurde weiterhin unter Rückfluß gekocht, bis kein Wasser mehr abgeschieden wurde. Nach Abühlung auf Raumtemperatur wurde zunächst das ausgefallene NaCl abfiltriert. Dann erfolgte die Abdestillation des überschüssigen Epichlorhydrins (gegen Ende unter Vakuum von 15 mbar, bei Sumpftemperatur von 90°C).

Das EEW des Produktes wurde zu 320 bestimmt. Eine Mischung von 100 g des Produktes mit 150 g eines Bisphenol-A-Standardharzes wurde mit der stöchiometrischen Menge von a) MHHPSA und b) Dicyandiamid ausgehärtet (2 Stunden bei 140°C bzw. 2 Stunden bei 170°C). Die Probekörper beider Aushärtungen erfüllten V0 nach UL 94.

### Beispiel 8 (Vergleich)

Umsetzung einer säurefunktonalisierten, ringgeschlossenen Phosphorverbindung mit einem Bisphenol-A-Standardharz:

DOP 118 wurde zunächst mit Itaconsäure umgesetzt und durch Auskristallisieren gereinigt. Das Umsetzungsprodukt, es sei DOP-ITS genannt, ist ein weißes Pulver mit einem Schmelzpunkt von 188°C.

In einem Vierhalskolben mit Rührer, Rückflußkühler und Thermofühler wurden 400 g eines Bisphenol-A-Standardharzes sowie 0,06% eines Katalysators bei 160°C vorgelegt. 100 g DOP-ITS wurden in kleinen Portionen zugegeben. Nach beendeter Zugabe wurde weitere 2 Stunden bei 160°C gerührt. Als Produkt erhielt man ein leicht gelbliches, hochviskoses Harz. Das Epoxyäquivalentgewicht wurde zu 270 bestimmt.

Mit der stöichiometrischen Menge an MHHPSA wurden Probekörper hergestellt (Aushärtung 2 Stunden bei 140°C). Diese erfüllten im Brandtest V1 nach UL94.

Das in den vorstehenden Beispielen erwähnte DOP oder dessen am Benzolkern substituierte Derivate können aus 2-Hydroxybiphenyl oder dessen kernsubstituierten Derivaten und Phosphortrichlorid synthetisiert werden (vgl. J.P.-AS 45397/1974). Bei der Herstellung des erfindungsgemäßen Flammschutzmittels ist darauf zu achten, daß die eingesetzten Mengen der Ausgangsmaterialien so gewählt werden, daß der Phosphorgehalt in dem erhaltenen Flammschutzmittel vorzugsweise innerhalb der oben angegebebenen Bereiche liegt. Wenn der Phosphorgehalt des Flammschutzmittels zu niedrig ist, kann das Flammhemmungsvermögen des erhaltenen Flammschutzmittels nicht ausreichend sein. Ist umgekehrt der Phosphorgehalt in dem Flammschutzmittel zu hoch, dann kann es schwierig sein, ein zufriedenstellendes Endprodukt zu erhalten.

Bei den erfindungsgemäßen flammfesten Epoxidharzen in unvernetzter, teilweise vernetzter oder vernetzter Form kann der Phosphorgehalt niedriger sein als bei den erfindungsgemäßen Flammschutzmitteln. Dies ergibt sich aus den oben angegebenen Bereichen.

Die mechanischen Eigenschaften der erfindungsgemäßen flammfesten Epoxidharze sind so gut, daß kein wahrnehmbarer Unterschied zu den Eigenschaften von entsprechenden Produkten festzustellen ist, die ohne Verwendung der erfindungsgemäßen Flammschutzmittel hergestellt worden sind. Anders kann es allerdings sein, wenn eine zu große Menge des Flammschutzmittels verwendet wird.

Wie aus den angegebenen Formeln ersichtlich, sind in den Ansprüchen und der Beschreibung unter Derivaten der 4-Hydroxy-butan-1-phosphinsäure auch Derivate der 4-Hydroxy-2-buten-1-phosphinsäure sowie der 4-Hydroxy-1,3-butadien-1-phosphinsäure zu verstehen.

## Patentansprüche

1. Derivat der 4-Hydroxy-butan-1-phosphinsäure und/oder ihres intramolekularen Esters entsprechend folgenden Formeln: 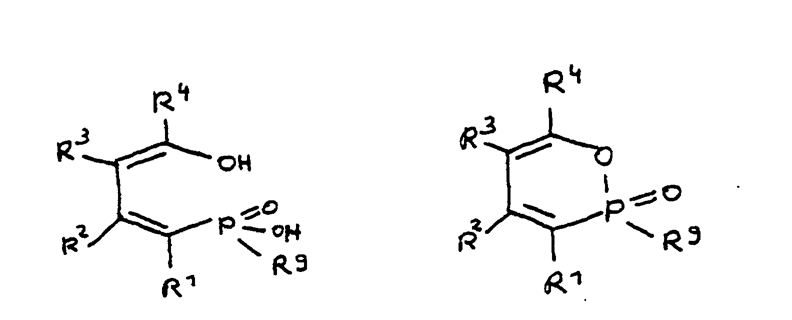 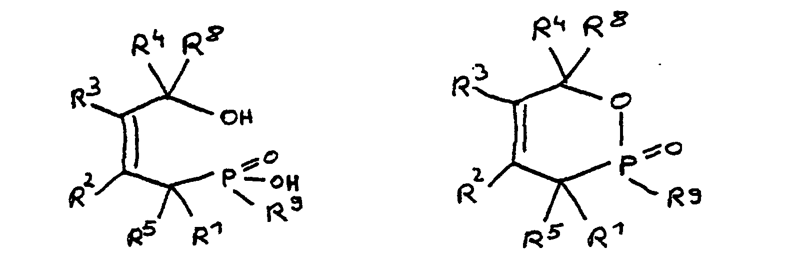 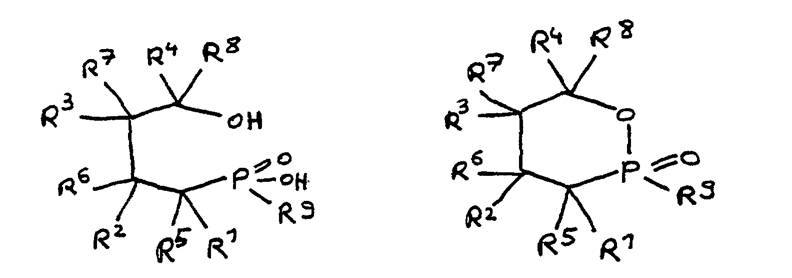 in denen R¹ bis R⁸ unabhängig voneinander Wasserstoff oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, mit der Maßgabe, daß höchstens drei der Reste R¹ bis R⁴ Wasserstoff sind, und zwei oder mehr der Reste R¹ bis R⁸ unter Ausbildung von Cyclen verknüpft sein können, und
R⁹ eine Gruppe ist, die mindestens eine Epoxyfunktion aufweist, wobei R⁹
(i) eine aliphatische, alicyclische oder aromatische Kohlenwasserstoffgruppe ist, die mindestens eine Epoxyfunktion aufweist, oder
(ii) eine Alkylaryl- oder Arylalkylgruppe ist, die mindestens eine Epoxyfunktion aufweist, oder
(iii) von dem Addukt aus Bisphenol A und Epichlorhydrin abgeleitet ist und der Formel 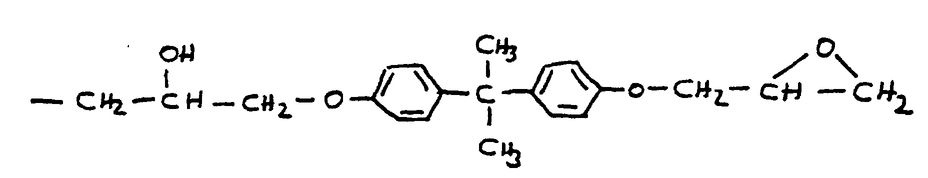 entspricht, oder
(iv) von dem Addukt aus Bisphenol F und Epichlorhydrin abgeleitet ist, oder
(v) von novolakbasierten Epoxidharzen und/oder novolak-/kresolbasierten Epoxidharzen abgeleitet ist, oder
(vi) von Reaktivverdünnern abgeleitet ist, welche mindestens eine Verbindung ausgewählt aus di- bis pentaepoxidfunktionellen aliphatischen, cycloaliphatischen oder aromatischen Verbindungen enthalten, oder
(vii) von N-Glycidylverbindungen aus aromatischen oder cycloaliphatischen Aminen oder Polyaminen abgeleitet ist.

2. Derivat nach Anspruch 1, **dadurch gekennzeichnet, daß** es einen Phosphorgehalt von 2 bis 16 Gew.-% aufweist.

3. Derivat nach Anspruch 1 oder 2, **dadurch gekennzeichnet, daß** R¹ bis R⁸ zusammen 6 bis 100 Kohlenstoffatome enthalten.

4. Derivat der 4-Hydroxy-butan-1-phosphinsäure und/oder ihres intramolekularen Esters nach Anspruch 3, **dadurch gekennzeichnet, daß** die Esterform folgender Formel entspricht: 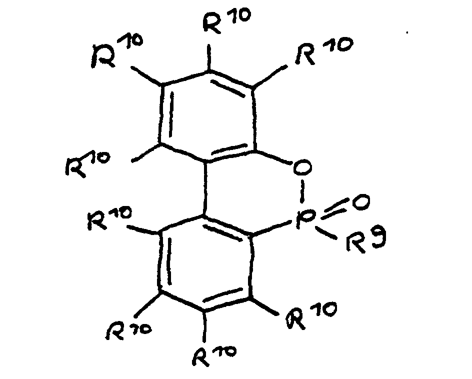 in der R⁹ die angegebene Bedeutung hat und
die Reste R¹⁰ unabhängig voneinander Wasserstoff, Halogen oder eine Kohlenwasserstoffgruppe sind, die gegebenenfalls ein oder mehrere Heteroatome ausgewählt aus Sauerstoff, Stickstoff, Schwefel, Phosphor, Silicium und Halogen enthält, wobei zwei oder mehr der Reste R¹⁰ unter Ausbildung von Cyclen verknüpft sein können.

5. Derivat nach einem der Ansprüche 1 bis 4, **dadurch gekennzeichnet, daß** R⁹ von Epichlorhydrin abgeleitet ist und der Formel 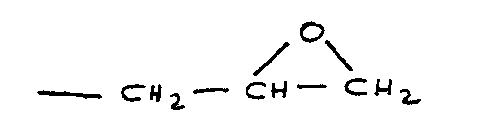 entspricht.

6. Verfahren zur Herstellung einer Zusammensetzung mit flammhemmenden Eigenschaften, **dadurch gekennzeichnet, daß** man
a) mindestens ein Derivat der 4-Hydroxy-butan-1-phosphinsäure und/oder ihres intramolekularen Esters entsprechend folgenden Formeln: 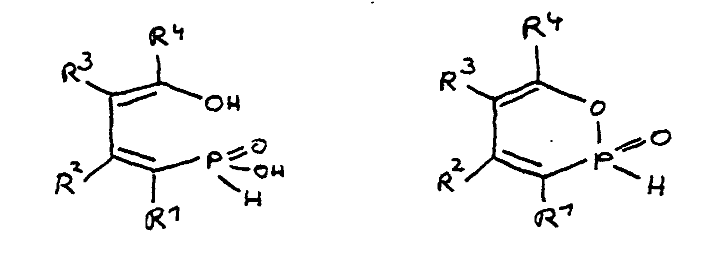 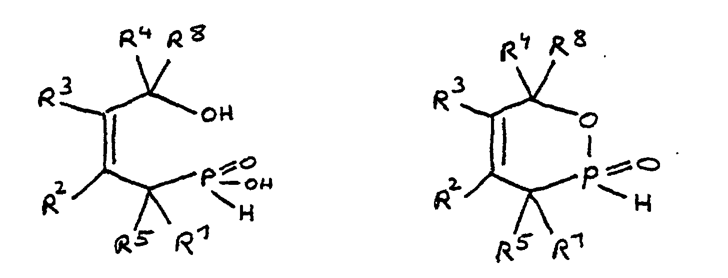 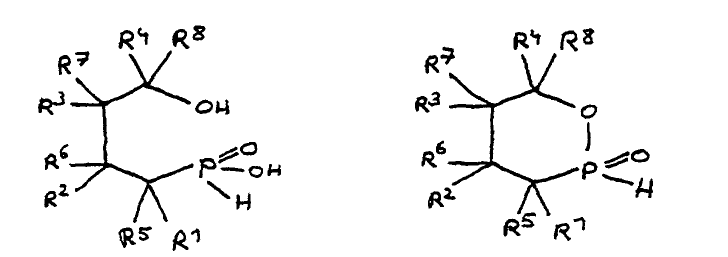 in denen R¹ bis R⁸ unabhängig voneinander Wasserstoff oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, mit der Maßgabe, daß höchstens drei der Reste R¹ bis R⁴ Wasserstoff sind, wobei zwei oder mehr der Reste R¹ bis R⁸ unter Ausbildung von Cyclen verknüpft sein können, mit
b) mindestens einer Komponente umsetzt, die im Molekül mindestens eine Epoxidgruppe aufweist und in der Lage ist, mit der Phosphingruppe des Derivats a) unter Ausbildung einer Phosphor-Kohlenstoff-Bindung zu reagieren,
und die als Reaktionsprodukt erhaltene Zusammensetzung reaktive Epoxidgruppen aufweist, wobei man als Komponente b)
Epichlorhydrin oder
das Addukt aus Bisphenol A und Epichlorhydrin oder
das Addukt aus Bisphenol F und Epichlorhydrin oder
eine Mischung aus dem Addukt aus Bisphenol F und Epichlorhydrin mit dem Addukt aus Bisphenol A und Epichlorhydrin oder
novolakbasierte Epoxidharze und/oder novolak-/kresolbasierte Epoxidharze oder
Reaktivverdünner, welche mindestens eine Verbindung ausgewählt aus di- bis pentaepoxidfunktionellen aliphatischen, cycloaliphatischen oder aromatischen Verbindungen enthalten, oder
N-Glycidylverbindungen aus aromatischen oder cycloaliphatischen Aminen oder Polyaminen verwendet.

7. Verfahren nach Anspruch 6, **dadurch gekennzeichnet, daß** man als Komponente a) ein Derivat mit einem Phosphorgehalt von 4 bis 29 Gew.-% verwendet.

8. Verfahren nach Anspruch 6 oder 7, **dadurch gekennzeichnet, daß** man ein Reaktionsprodukt mit einem Phosphorgehalt von 2 bis 16 Gew.-% herstellt.

9. Verfahren nach einem der Ansprüche 6 bis 8, **dadurch gekennzeichnet, daß** man als Komponente a) ein Derivat verwendet, bei dem die Reste R¹ bis R⁸ zusammen 6 bis 100 Kohlenstoffatome enthalten.

10. Verfahren nach Anspruch 9, **dadurch gekennzeichnet, daß** man ein Derivat der 4-Hydroxy-butan-1-phosphinsäure und/oder ihres intramolekularen Esters verwendet, dessen Esterform folgender Formel entspricht: 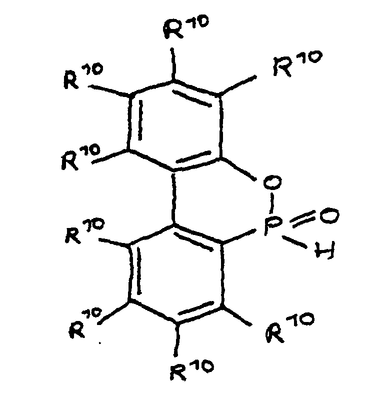 in der die Reste R¹⁰ unabhängig voneinander Wasserstoff, Halogen oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, wobei zwei oder mehr der Reste R¹⁰ unter Ausbildung von Cyclen verknüpft sein können.

11. Zusammensetzung mit flammhemmenden Eigenschaften, welche reaktive Epoxidgruppen aufweist, erhältlich nach dem Verfahren gemäß einem der Ansprüche 6 bis 10.

12. Verwendung der Zusammensetzung gemäß Anspruch 11 als Flammschutzmittel für (i) Epoxidharze in unvernetzter, teilweise vernetzter oder vernetzter Form, (ii) unter Verwendung von Epoxidharzen hergestellte Erzeugnisse, und (iii) Zusammensetzungen, die niedermolekulare Epoxidverbindungen enthalten oder aus diesen bestehen, insbesondere Reaktiwerdünner.

13. Verwendung von Derivaten der 4-Hydroxy-butan-1-phosphinsäure und/oder ihres intramolekularen Esters entsprechend folgenden Formeln: 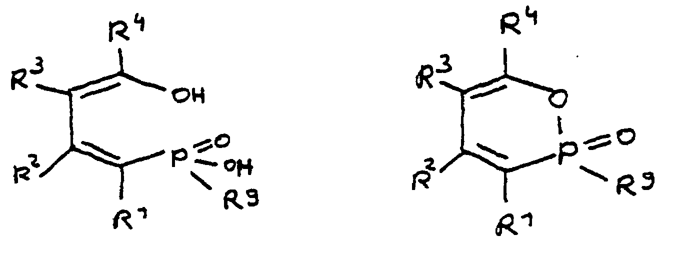 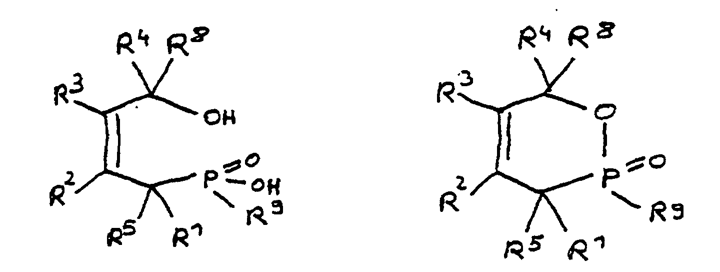 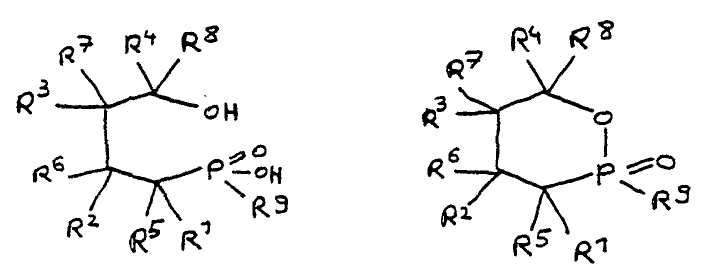 in denen R¹ bis R⁸ unabhängig voneinander Wasserstoff oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, mit der Maßgabe, daß höchstens drei der Reste R¹ bis R⁴ Wasserstoffatome sind, wobei zwei oder mehr der Reste R¹ bis R⁸ unter Ausbildung von Zyklen verknüpft sein können, und
R⁹ Wasserstoff ist oder
R⁹ eine Gruppe ist, die mindestens eine Epoxyfunktion aufweist, wobei R⁹
(i) eine aliphatische, alicyclische oder aromatische Kohlenwasserstoffgruppe ist, die mindestens eine Epoxyfunktion aufweist, oder
(ii) eine Alkylaryl- oder Arylalkylgruppe ist, die mindestens eine Epoxyfunktion aufweist, oder
(iii) von dem Addukt aus Bisphenol A und Epichlorhydrin abgeleitet ist und der Formel 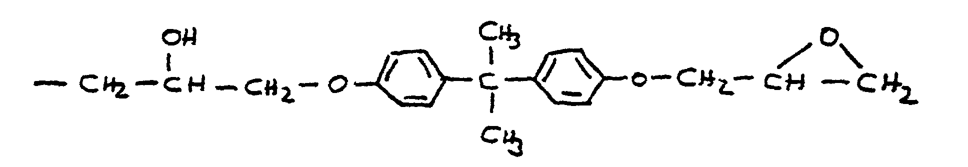 entspricht, oder
(iv) von dem Addukt aus Bisphenol F und Epichlorhydrin abgeleitet ist, oder
(v) von novolakbasierten Epoxidharzen und/oder novolak/kresolbasierten Epoxidharzen abgeleitet ist, oder
(vi) von Reaktivverdünnern abgeleitet ist, welche mindestens eine Verbindung ausgewählt aus di- bis pentaepoxidfunktionellen aliphatischen, cycloaliphatischen oder aromatischen Verbindungen enthalten, oder
(vii) von N-Glycidylverbindungen aus aromatischen oder cycloaliphatischen Aminen oder Polyaminen abgeleitet ist,
als Flammschutzmittel für (x) Epoxidharze in unvernetzter, teilweise vernetzter oder vernetzter Form, (y) unter Verwendung von Epoxidharzen hergestellte Erzeugnisse und (z) Zusammensetzungen, die niedermolekulare Epoxidharzverbindungen enthalten oder aus ihnen bestehen, insbesondere Reaktivverdünner.

14. Verwendung nach Anspruch 13, **dadurch gekennzeichnet, daß** das Derivat einen Phosphorgehalt von 2 bis 16 Gew.-% aufweist.

15. Verwendung nach Anspruch 13 oder 14, **dadurch gekennzeichnet, daß** die Reste R¹ bis R⁸ zusammen 6 bis 100 Kohlenstoffatome enthalten.

16. Verwendung nach Anspruch 15, **dadurch gekennzeichnet, daß** es sich um ein Derivat der 4-Hydroxy-butan-l-phosphinsäure und/oder ihres intramolekularen Esters handelt, bei dem die Esterform der folgenden Formel entspricht: 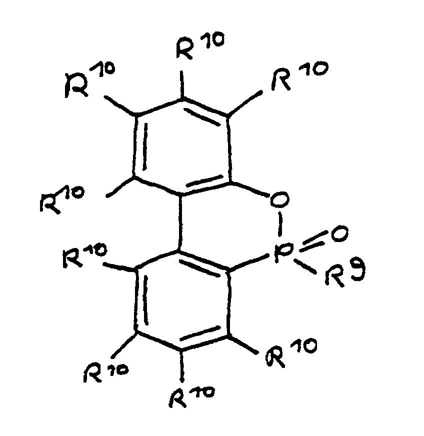 in der R⁹ die angegebene Bedeutung hat und
die Reste R¹⁰ unabhängig voneinander Wasserstoff, Halogen oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, wobei zwei oder mehr der Reste R¹⁰ unter Ausbildung von Cyclen verknüpft sein können.

17. Verwendung nach einem der Ansprüche 12 bis 16, **dadurch gekennzeichnet, daß** man das Flammschutzmittel mit dem unvernetzten oder teilweise vernetzten Epoxidharz vermischt, mindestens einen Härter zusetzt und die so erhaltene Zusammensetzung unter Aushärten in das gewünschte Erzeugnis überführt.

18. Flammfestes Epoxidharz in unvernetzter oder teilweise vernetzter Form oder in Form eines unter Vernetzung und Aushärtung erhaltenen Erzeugnisses, erhalten unter Verwendung eines Flammschutzmittels gemäß einem der Ansprüche 12 bis 17.

19. Epoxidharz nach Anspruch 18, **dadurch gekennzeichnet, daß** es 2 bis 7 Gew.-% Phosphor in der Harzmasse enthält, wobei unter Harzmasse das Gesamtgewicht von eingesetztem Harz und Flammschutzmittel ohne Berücksichtigung weiterer Bestandteile wie Härter, Füllstoff oder Glasfasermatte zu verstehen ist.

20. Epoxidharz nach Anspruch 19, **dadurch gekennzeichnet, daß** mindestens ein Teil des Flammschutzmittels mit dem Epoxidharz und/oder dem gegebenenfalls eingesetzten Härter reagiert hat, so daß mindestens 50 Gew.% des Phosphorgehaltes chemisch an das Epoxidharz gebunden sind.

21. Flammfestes Epoxidharz, welches 2 bis 7 Gew.-% Phosphor in der Harzmasse enthält, wobei unter Harzmasse das Gesamtgewicht von eingesetztem Harz und Flammschutzmittel ohne Berücksichtigung weiterer Komponenten wie Härter, Füllstoff oder Glasfasermatte zu verstehen ist, und welches als Teil seiner unvernetzten, teilweise vernetzten oder vernetzten Struktur Einheiten aufweist, die von mindestens einem Derivat der 4-Hydroxy-butan-1-phosphinsäure und/oder ihrem intramolekularen Ester abgeleitet und über deren Phosphoratom an das Harz gebunden sind, wobei die Einheiten folgenden Formeln 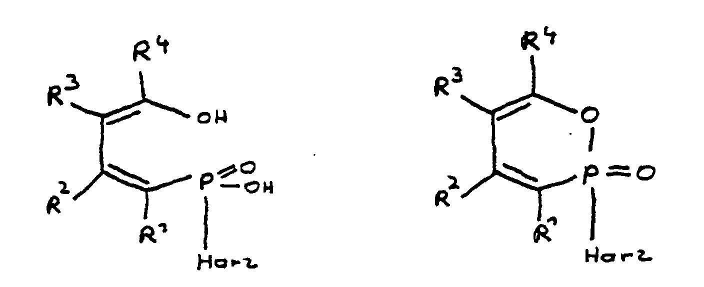 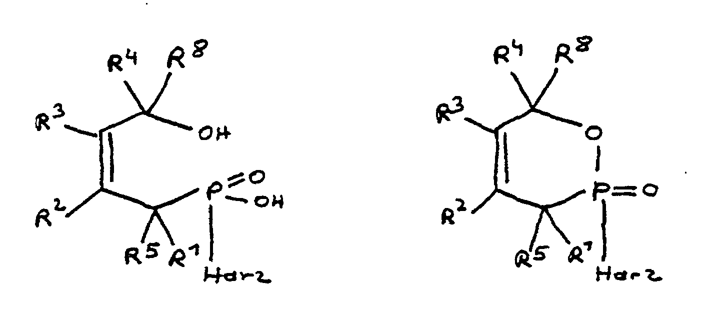 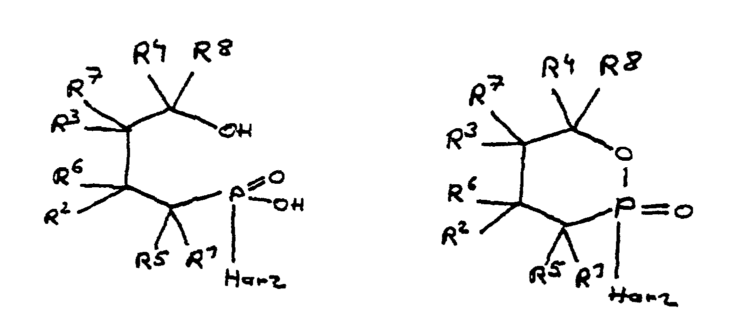 entsprechen, in denen R¹ bis R⁸ unabhängig voneinander Wasserstoff oder eine Kohlenwasserstoffgruppe sind, die gegebenenfalls ein oder mehrere Heteroatome ausgewählt aus Sauerstoff, Stickstoff, Schwefel, Phosphor, Silicium oder Halogen enthält, wobei zwei oder mehr der Reste R¹ bis R⁸ unter Ausbildung von Cyclen verknüpft sein können.

22. Epoxidharz nach Anspruch 21, **dadurch gekennzeichnet, daß** höchstens drei der Reste R¹ bis R⁴ Wasserstoff sind.

23. Epoxidharz nach Anspruch 21 oder 22, **dadurch gekennzeichnet, daß** die Reste R¹ bis R⁸ zusammen 6 bis 100 Kohlenstoffatome enthalten.

24. Epoxidharz nach Anspruch 23, **dadurch gekennzeichnet, daß** es Einheiten aufweist, die von der 4-Hydroxy-butan-1-phosphinsäure oder ihrem intramolekularem Ester abgeleitet sind, wobei die Esterform der Einheiten folgender Formel entspricht: 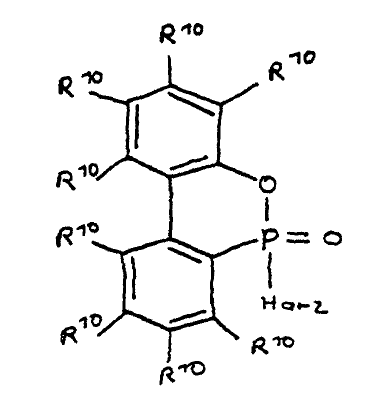 in der die Reste R¹⁰ unabhängig voneinander Wasserstoff, Halogen oder eine Kohlenwasserstoffgruppe sind, die gegebenenfalls ein oder mehrere Heteroatome ausgewählt aus Sauerstoff, Stickstoff, Schwefel, Phosphor, Silicium und Halogen enthält, wobei zwei oder mehr der Reste R¹⁰ unter Ausbildung von Cyclen verknüpft sein können.

25. Verwendung des Epoxidharzes nach einem der Ansprüche 18 bis 24 zur Herstellung von Formkörpern oder Überzügen mit flammhemmenden Eigenschaften.

26. Prepregs und Verbundwerkstoffe auf der Basis von anorganischen oder organischen Verstärkungsmaterialien in Form von Fasern, Vliesen oder Geweben oder von Flächenstoffen, hergestellt aus einem Epoxidharz nach einem der Ansprüche 18 bis 24.

27. Leiterplatten aus Prepregs, hergestellt aus Glasfasergewebe und Epoxidharzmischungen nach einem der Ansprüche 18 bis 24.

28. Leiterplatten nach Anspruch 27, **dadurch gekennzeichnet, daß** die als Flammschutzmittel verwendete Zusammensetzung von mindestens einem Derivat des intramolekularen Esters der 4-Hydroxy-butan-1-phosphinsäure abgeleitet ist.

29. Verwendung nach einem der Ansprüche 12 bis 17 beim Einsatz von Epoxidharz im Elektronikbereich, wobei die als Flammschutzmittel verwendete Zusammensetzung von mindestens einem Derivat des intramolekularen Esters der 4-Hydroxy-butan-1-phosphinsäure abgeleitet ist.

## Claims

1. Derivatives of 4-hydroxy-butane-1-phosphinic acid and/or their intramolecular esters according to the following formulae: 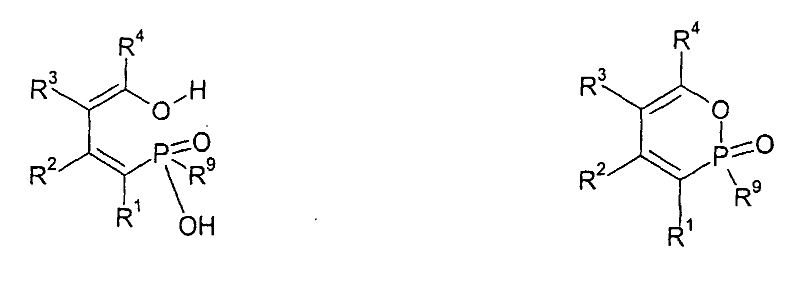 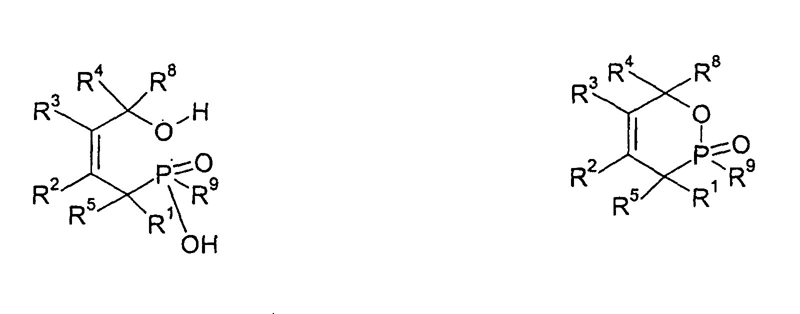 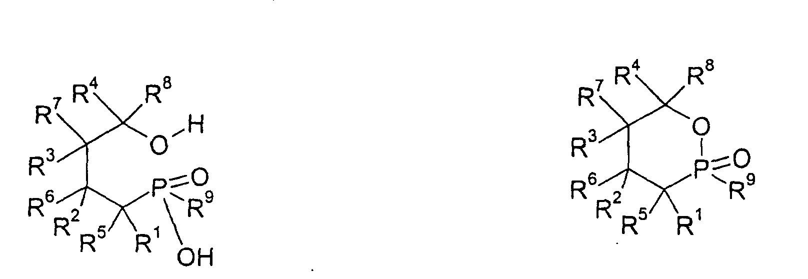 in which R¹ to R⁸ are independently of one another a hydrogen atom or a hydrocarbon radical and which optionally contains one or more heteroatoms selected from oxygen, nitrogen, sulphur, phosphorus, silicon or halogen, provided that at most three of the radicals R¹ to R⁴ are hydrogen and that two or more of the radicals R' to R⁸ can be linked through the presence of cyclic structures, and R⁹ is a radical which contains at least one epoxy group, wherein R⁹ is
(i) an aliphatic, alicyclic or aromatic hydrocarbon radical that contains at least one epoxy group, or
(ii) an alkaryl or aralkyl radical that contains at least one epoxy group, or
(iii) an adduct derived from Bisphenol A and epichlorohydrin, according to the formula 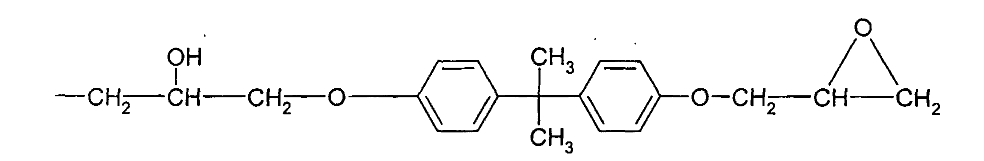 or,
(iv) an adduct derived from Bisphenol F and epichlorohydrin, or
(v) derived from Novolac-based epoxy resins and/or Novolac/cresol-based epoxy resins, or
(vi) derived from reactive diluents, which contain at least one compound selected from di- to penta-epoxy functional aliphatic, cycloaliphatic or aromatic compounds, or
(vii) derived from N-glycidyl compounds of aromatic or cycloaliphatic amines or polyamines.

2. Derivatives as defined in Claim 1, wherein the phosphorus content ranges from 2-16% by weight.

3. Derivatives as defined in Claims 1 or 2, wherein the sum of the carbon atoms contained in the radicals R¹ to R⁸ ranges from 6 to 100.

4. Derivatives of 4-hydroxy-butane-1-phosphinic acid and/or its intramolecular esters as defined in Claim 3, wherein the ester form corresponds to the following formula: 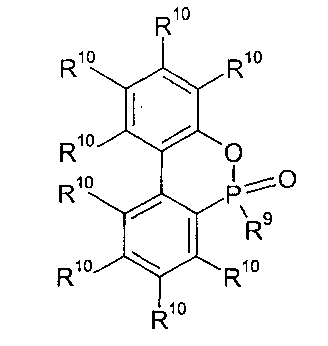 in which R⁹ is as previously described and
the radicals R¹⁰ are independently of one another hydrogen, halogen or a hydrocarbon radical which optionally contains one or more heteroatoms selected from oxygen, nitrogen, sulphur, phosphorus, silicon and halogen, whereby two or more of the radicals R¹⁰ can be linked through the presence of cyclic structuress.

5. Derivatives as defined in Claims I to 4, wherein R⁹ derives from epichlorohydrin and corresponds to the following formula

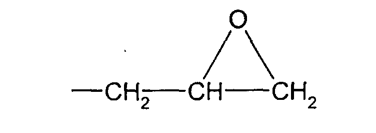

6. A process for preparing a flame retardant composition, comprising the reaction of
a) at least one derivative of 4-hydroxy-butane-1-phosphinic acid and/or its intramolecular ester according to the following formulae: 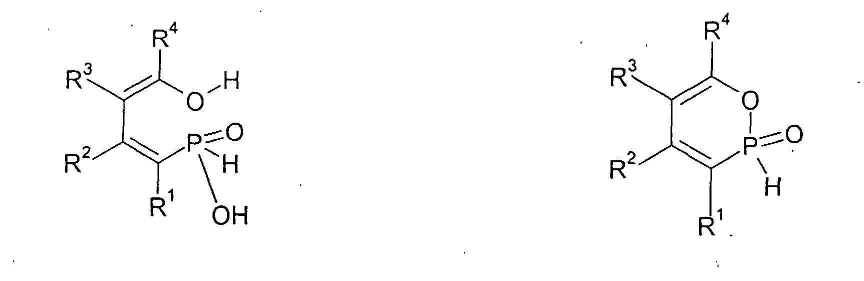 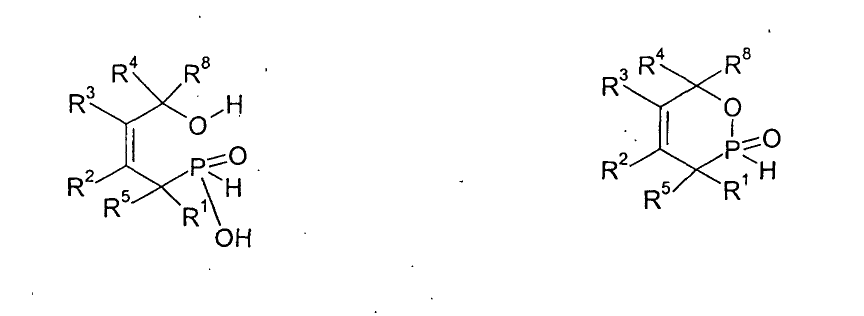 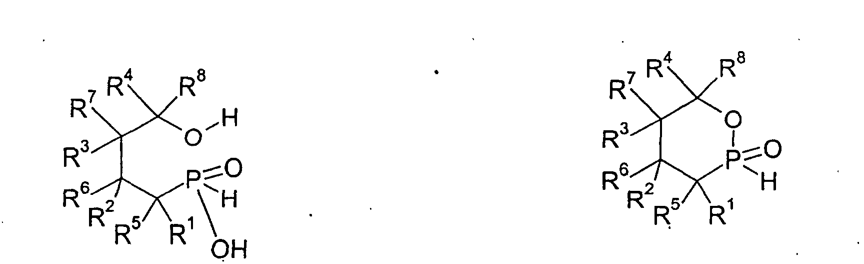 in which R¹ to R⁸ are independently of one another a hydrogen atom or a hydrocarbon radical and which optionally contains one or more heteroatoms selected from oxygen, nitrogen, sulphur, phosphorus, silicon or halogen, provided that at most three of the radicals R¹ to R⁴ are hydrogen and that two or more of the radicals R¹ to R⁸ can be linked through the presence of cyclic structures, with
b) at least one added component containing a molecule with at least one epoxy group and which can react with the phosphinic group of derivative a) to form a phosphorus - carbon bond,
and the resulting composition of the reaction product that contains epoxy groups, whereby component b) is
Epichlorohydrin or
the adduct of Bisphenol A and epichlorohydrin or
the adduct of Bisphenol F and epichlorohydrin or
a mixture of the adduct of Bisphenol F and epichlorohydrin with the adduct of Bisphenol A and epichlorohydrin or
Novolac-based epoxy resins and/or Novolac/cresol-based epoxy resins or
reactive diluents, which contain at least one compound selected from di- to penta-epoxy functional aliphatic, cycloaliphatic or aromatic compounds, or
N-glycidyl compounds of aromatic or cycloaliphatic amines or polyamines.

7. The process as defined in Claim 6, whereby component a) is a derivative that has a phosphorus content ranging from 4 to 29% by weight.

8. The process as defined in Claims 6 or 7, whereby a reaction product is prepared that contains a phosphorus content ranging from 2 to 16% by weight.

9. The process as defined in one of the Claims 6 to 8, whereby a derivative is used wherein the sum of the carbon atoms contained in the radicals R¹ to R⁸ ranges from 6 to 100.

10. The process as defined in Claim 9, comprising the use of a derivative of 4-hydroxybutane-1-phosphinic acid and/or its intramolecular ester, whereby the ester has the following formula: 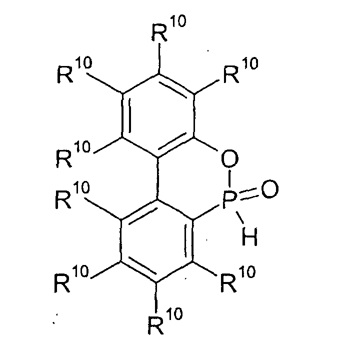 in which the radicals R¹⁰ are independently of one another hydrogen, halogen or a hydrocarbon radical which optionally contains one or more heteroatoms selected from oxygen, nitrogen, sulphur, phosphorus, silicon and halogen, whereby two or more of the radicals R¹⁰ can be linked through the presence of cyclic structures.

11. A flame retardant composition comprising reactive epoxy groups, and obtained according to the processes defined in one of the Claims 6 to 10.

12. Use of the composition described in Claim 11 as a flame retardant for (i) thermoplastic, partially crosslinked or crosslinked epoxy resins, (ii) products manufactured from epoxy resins, and (iii) compositions which contain low molecular weight epoxy compounds or which are constituted from them, particularly reactive diluents.

13. Use of the derivatives of 4-hydroxy-butane-1-phosphinic acid and/or its intramolecular esters according to the following formulae: 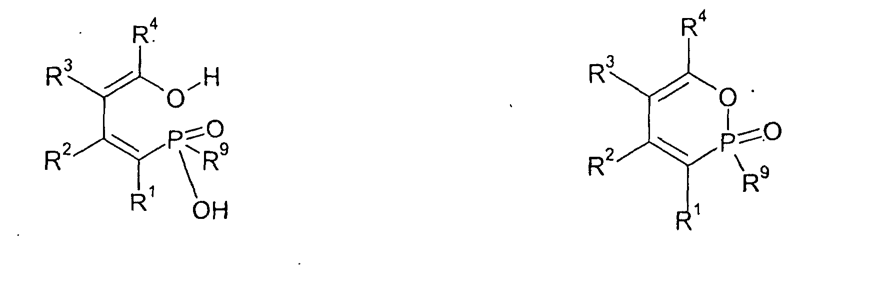 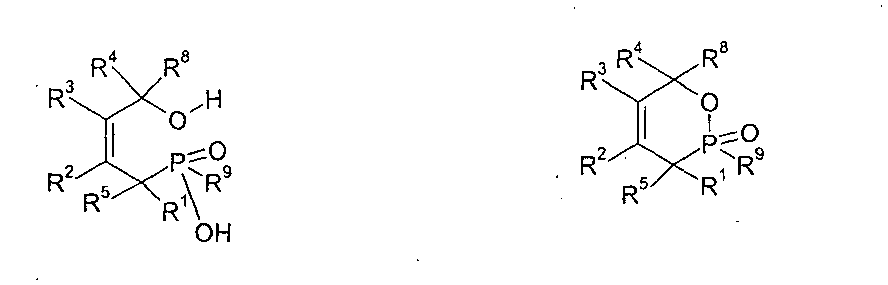 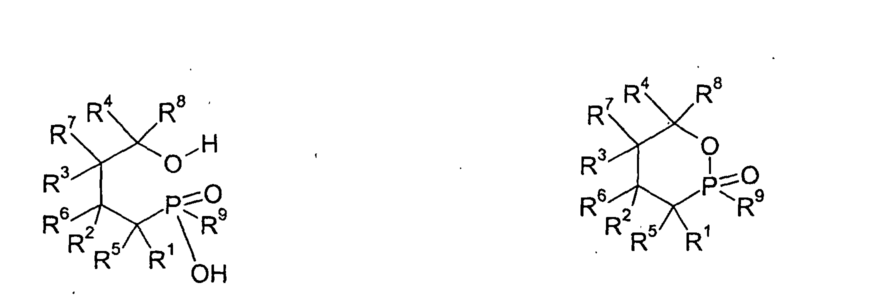 in which R¹ to R⁸ are independently of one another a hydrogen atom or a hydrocarbon radical and which optionally contains one or more heteroatoms selected from oxygen, nitrogen, sulphur, phosphorus, silicon or halogen, provided that at most three of the radicals R¹ to R⁴ are hydrogen and that two or more of the radicals R¹ to R⁸ can be linked through the presence of cyclic structures, and
R⁹ is hydrogen or
R⁹ is a radical which contains at least one epoxy group, wherein R⁹ is
(i) an aliphatic, alicyclic or aromatic hydrocarbon radical that contains at least one epoxy group, or
(ii) an alkaryl or aralkyl radical that contains at least one epoxy group, or
(iii) an adduct derived from Bisphenol A and epichlorohydrin, according to the formula 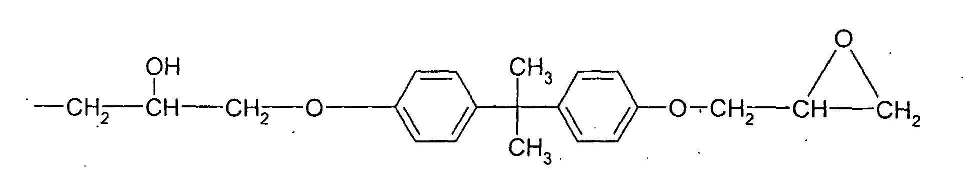 or,
(iv) an adduct derived from Bisphenol F and epichlorohydrin, or
(v) derived from Novolac-based epoxy resins and/or Novolac/cresol-based epoxy resins, or
(vi) derived from reactive diluents, which contain at least one compound selected from di- to penta-epoxy functional aliphatic, cycloaliphatic or aromatic compounds, or
(vii) derived from N-glycidyl compounds of aromatic or cycloaliphatic amines or polyamines,
as flame retardants for (x) thermoplastic, partially crosslinked or crosslinked epoxy resins, (y) products manufactured from epoxy resins, and (z) compositions which contain low molecular weight epoxy resin compounds or which are constituted from them, particularly reactive diluents.

14. Use as described in Claim 13, whereby the derivative contains a phosphorus content ranging from 2 to 16% by weight.

15. Use as described in Claims 13 or 14, whereby the sum of the carbon atoms contained in the radicals R¹ to R⁸ ranges from 6 to 100.

16. Use as described in Claim 15, **characterised by** the use of a derivative of 4-hydroxybutane-1-phosphinic acid and/or its intramolecular ester, whereby the ester has the following formula: 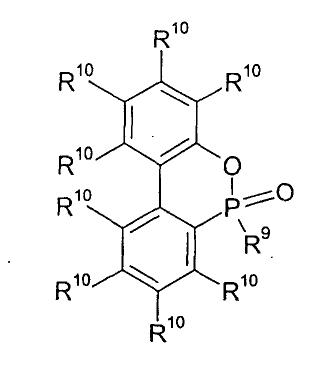 in which R⁹ is as previously described and
the radicals R¹⁰ are independently of one another hydrogen, halogen or a hydrocarbon radical which optionally contains one or more heteroatoms selected from oxygen, nitrogen, sulphur, phosphorus, silicon and halogen, whereby two or more of the radicals R¹⁰ can be linked through the presence of cyclic structures.

17. Use as described in one of the Claims 12 to 16, whereby the flame retardant is blended with the thermoplastic or partially crosslinked epoxy resin, at least one curing agent or accelerator is added and the resulting composition is transformed with curing into the required product.

18. A flame-resistant epoxy resin in thermoplastic or partially crosslinked form or in the form of a product undergoing crosslinking and curing, obtained by the use of a flame retardant as described in Claims 12 to 17.

19. An epoxy resin as described in Claim 18, whereby the resinous composition contains a phosphorus content in the range 2 to 7% by weight, whereby the resinous composition is defined as the total weight of the added resin and flame retardant, but neglecting other constituents such as curing agents, fillers, or glass fibres.

20. Epoxy resin as described in Claim 19, whereby, at least a part of the flame retardant has reacted with the epoxy resin and/or the optionally added curing agent, so that at least 50% by weight of the phosphorus content is chemically bonded to the epoxy resin.

21. A flame-resistant epoxy resin, which contains from 2 to 7% by weight of phosphorus in the resinous composition, whereby the resinous composition is defined as the total weight of the resin and the flame retardant, but neglecting other constituents such as curing agents, fillers, or glass fibres and which a part of the thermoplastic or partially crosslinked or crosslinked structure is constituted by units which contain at least one derivative of 4-hydroxy-butane-1-phosphinic acid and/or its intramolecular ester and which are chemically bonded through the phosphorus atom to the resin, whereby the units correspond to the following formulae: 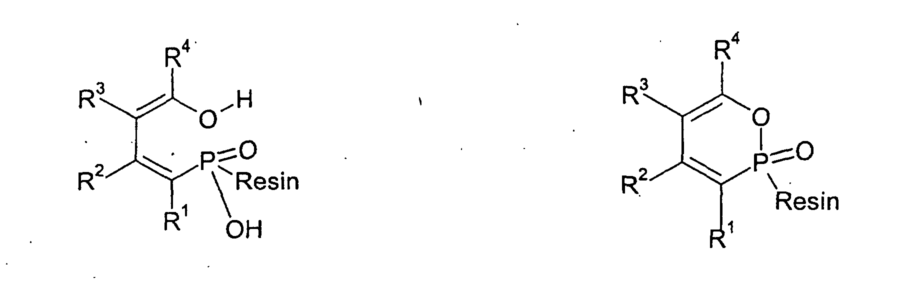 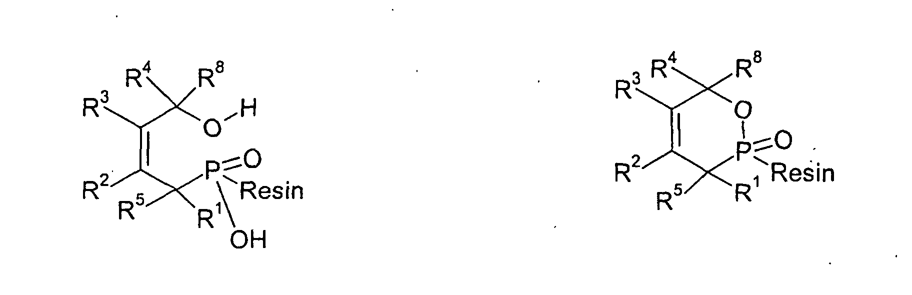 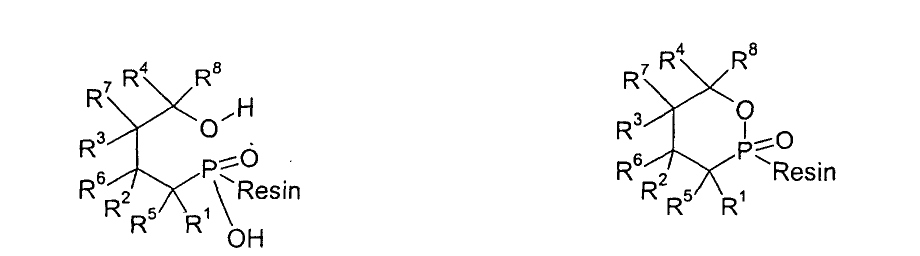 in which R¹ to R⁸ are independently of one another a hydrogen atom or a hydrocarbon radical and which optionally contains one or more heteroatoms selected from oxygen, nitrogen, sulphur, phosphorus, silicon or halogen, and that two or more of the radicals R¹ to R⁸ can be linked through the presence of cyclic structures.

22. An epoxy resin as defined in Claim 21, whereby at most three of the radicals R¹ to R⁴ are hydrogen.

23. An epoxy resin as described in Claims 21 or 22, whereby the sum of the carbon atoms contained in the radicals R¹ to R⁸ ranges from 6 to 100.

24. An epoxy resin as described in Claim 23, comprising units that are derivatives of 4-hydroxy-butane-1-phosphinic acid and/or its intramolecular ester and which are chemically bonded through the phosphorus atom to the resin, whereby the ester form of the units correspond to the following formulae: 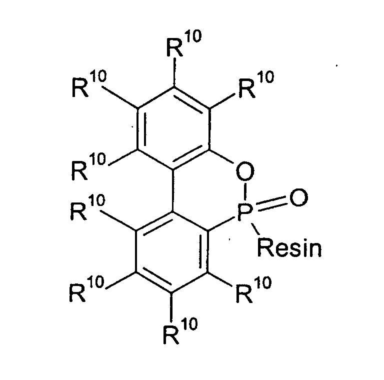 in which R¹⁰ are independently of one another a hydrogen atom, halogen or a hydrocarbon radical and which optionally contains one or more heteroatoms selected from oxygen, nitrogen, sulphur, phosphorus, silicon or halogen, and that two or more of the radicals R¹⁰ can be linked through the presence of cyclic structures.

25. Use of the epoxy resin as described in one of the Claims 18 to 24 for the manufacture of flame-resistant moulded objects or coatings.

26. Prepegs and composite materials that contain an inorganic or organic reinforcing material in the form of fibres, fleece, fabric or flat material and manufactured from an epoxy resin as described in one of the Claims 18 to 24.

27. Circuit boards made from prepregs manufactured from glass fibres and an epoxy resin mixture as described in one of the Claims 18 to 24.

28. Circuit boards as described in Claim 27, whereby the composition that is used as the flame retardant is derived from at least one of the intramolecular esters of 4-hydroxybutane-1-phosphinic acid.

29. Use as described in one of the Claims 12 to 27 **characterised by** the application of epoxy resins in the electronics field, whereby the composition that is used as the flame retardant is derived from at least one of the intramolecular esters of 4-hydroxy-butane1-phosphinic acid.

## Revendications

1. Dérivé de l'acide 4-hydroxybutane-1-phosphinique et/ou de son ester intramoléculaire, correspondant aux formules suivantes : 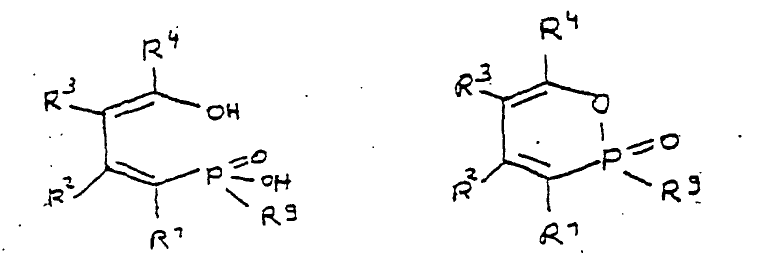 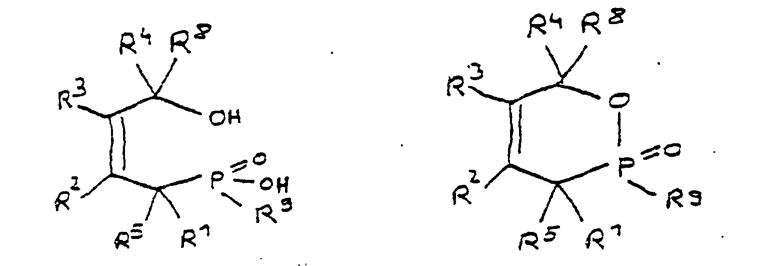 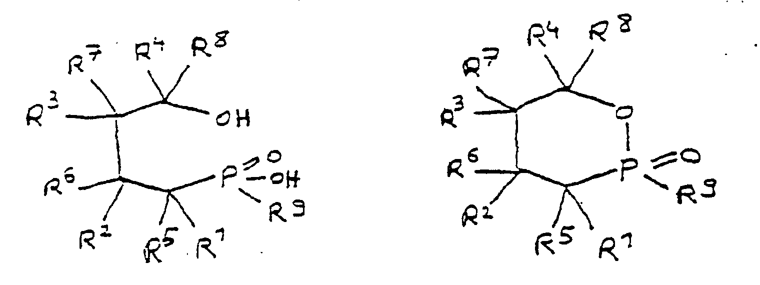 dans lesquelles R¹ à R⁸ représentent, indépendamment les uns des autres, un atome d'hydrogène ou un groupe hydrocarboné qui contient éventuellement un ou plusieurs hétéroatomes choisis parmi l'oxygène, l'azote, le soufre, le phosphore, le silicium ou un halogène, étant entendu qu'au maximum trois des radicaux R¹ à R⁴ représentent un atome d'hydrogène, et deux ou plus des radicaux R¹ à R⁸ peuvent être liés avec formation de cycles, et R⁹ est un groupe qui comporte au moins une fonction époxy, R⁹
(i) étant un groupe hydrocarboné aliphatique, alicyclique ou aromatique qui comporte au moins une fonction époxy, ou
(ii) étant un groupe alkylaryle ou arylalkyle qui comporte au moins une fonction époxy, ou
(iii) étant dérivé de l'adduit de bisphénol A et d'épichlorhydrine, correspondant à la formule 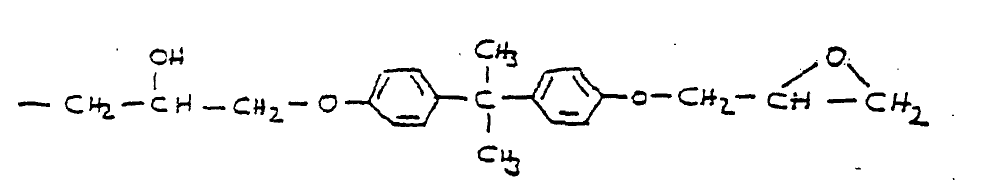 ou
(iv) étant dérivé de l'adduit de bisphénol F et d'épichlorhydrine, ou
(v) étant dérivé de résines époxy à base de Novolaque et/ou de résines époxy à base de Novolaque/crésol, ou
(vi) étant dérivé de diluants réactifs qui contiennent au moins un composé choisi parmi des composés aliphatiques, cycloaliphatiques ou aromatiques à fonction di- à pentaépoxyde, ou
(vii) étant dérivé de composés N-glycidyliques à base d'amines ou de polyamines aromatiques ou cycloaliphatiques.

2. Dérivé selon la revendication 1, **caractérisé en ce qu'**il présente une teneur en phosphore de 2 à 16 % en poids.

3. Dérivé selon la revendication 1 ou 2, **caractérisé en ce que** R¹ à R⁸ contiennent ensemble de 6 à 100 atomes de carbone.

4. Dérivé de l'acide 4-hydroxybutane-1-phosphinique et/ou de son ester intramoléculaire selon la revendication 3, **caractérisé en ce que** la forme ester correspond à la formule suivante : 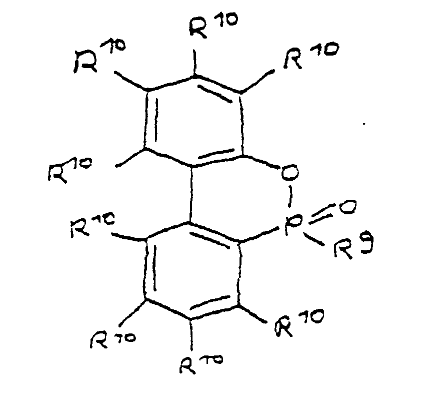 dans laquelle R⁹ a la signification indiquée, et
les radicaux R¹⁰ représentent; indépendamment les uns des autres, un atome d'hydrogène ou d'halogène ou un groupe hydrocarboné qui contient éventuellement un ou plusieurs hétéroatomes choisis parmi l'oxygène, l'azote, le soufre, le phosphore, le silicium et un halogène, deux ou plus de deux des radicaux R¹⁰ pouvant être liés avec formation de cycles.

5. Dérivé selon l'une quelconque des revendications 1 à 4, **caractérisé en ce que** R⁹ est dérivé d'épichlorhydrine et correspond à la formule

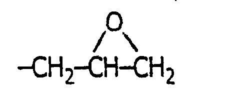

6. Procédé pour la préparation d'une composition à propriétés ignifuges, **caractérisé en ce qu'**on fait réagir
a) au moins un dérivé de l'acide 4-hydroxybutane-1-phosphonique et/ou de son ester intramoléculaire correspondant aux formules suivantes : 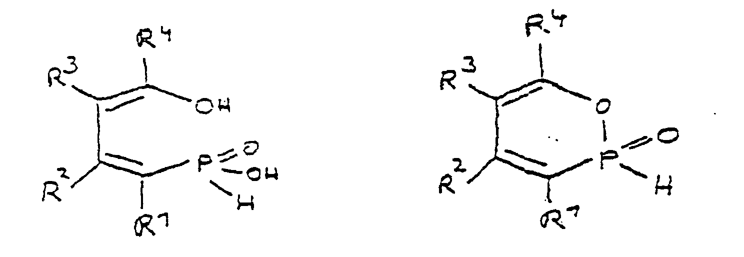 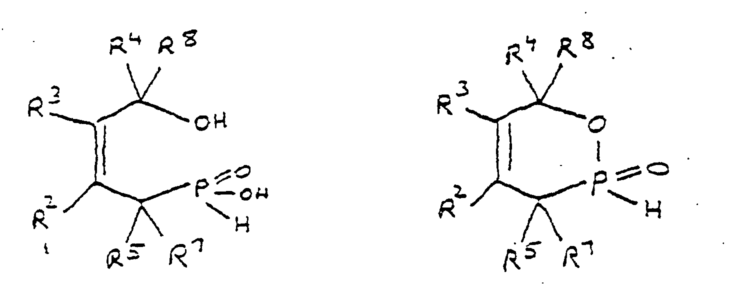 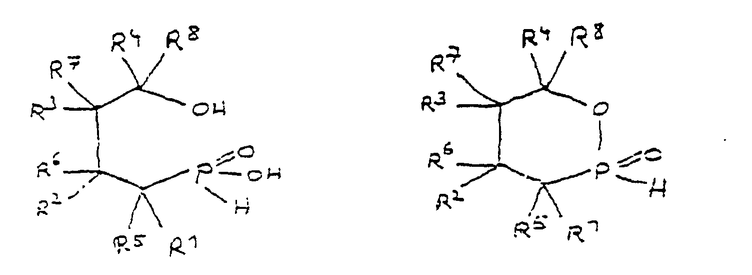 dans lesquelles R¹ à R⁸ représentent, indépendamment les uns des autres, un atome d'hydrogène ou un groupe hydrocarboné qui contient éventuellement un ou plusieurs hétéroatomes choisis parmi l'oxygène, l'azote, le soufre, le phosphore, le silicium ou un halogène, étant entendu qu'au maximum trois des radicaux R¹ à R⁴ représentent un atome d'hydrogène, deux ou plus de deux des radicaux R¹ à R⁸ pouvant être liés avec formation de cycles, avec
b) au moins un composant qui comporte dans sa molécule au moins un groupe époxy, et est capable de réagir avec le groupe phosphino du dérivé a) avec formation d'une liaison phosphore-carbone,
et la composition obtenue en tant que produit de réaction comporte des groupes époxy réactifs, en utilisant comme composant b)
l'épichlorhydrine ou
l'adduit de bisphénol A et d'épichlorhydrine ou
l'adduit de bisphénol F et d'épichlorhydrine ou
un mélange de l'adduit de bisphénol F et d'épichlorhydrine avec l'adduit de bisphénol A et d'épichlorhydrine ou
des résines époxy à base de Novolaque et/ou des résines époxy à base de Novolaque/crésol ou
des diluants réactifs qui contiennent au moins un composé choisi parmi des composés aliphatiques, cycloaliphatiques ou aromatiques à fonction di- à pentaépoxy, ou
des composés N-glycidyliques à base d'amines ou de polyamines aromatiques ou cycloaliphatiques.

7. Procédé selon la revendication 6, **caractérisé en ce qu'**on utilise comme composant a) un dérivé ayant une teneur en phosphore de 4 à 29 % en poids.

8. Procédé selon la revendication 6 ou 7, **caractérisé en ce qu'**on prépare un produit de réaction ayant une teneur en phosphore de 2 à 16 % en poids.

9. Procédé selon l'une quelconque des revendications 6 à 8, **caractérisé en ce qu'**on utilise comme composant a) un dérivé dans lequel les radicaux R¹ à R⁸ contiennent ensemble de 6 à 100 atomes de carbone.

10. Procédé selon la revendication 9, **caractérisé en ce qu'**on utilise un dérivé de l'acide 4-hydroxybutane-1-phosphinique et/ou son ester intramoléculaire, dont la forme ester correspond à la formule suivante : 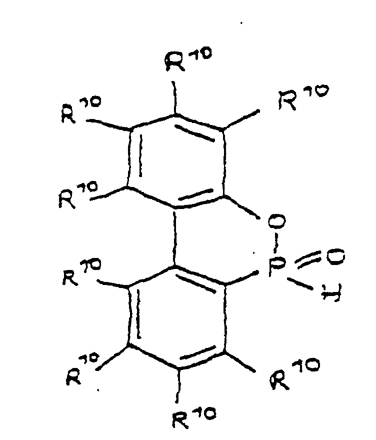 dans laquelle les radicaux R¹⁰ représentent, indépendamment les uns des autres, un atome d'hydrogène ou d'halogène ou un groupe hydrocarboné qui contient éventuellement un ou plusieurs hétéroatomes choisis parmi l'oxygène, l'azote, le soufre, le phosphore, le silicium et un halogène, deux ou plus de deux des radicaux R¹⁰ pouvant être liés avec formation de cycles.

11. Composition à propriétés ignifuges, qui comporte des groupes époxy réactifs, pouvant être obtenue par le procédé selon l'une quelconque des revendications 6 à 10.

12. Utilisation de la composition selon la revendication 11, en tant qu'agent ignifuge pour (i) des résines époxy sous forme réticulée, partiellement réticulée ou non réticulée, (ii) des produits préparés avec utilisation de résines époxy et (iii) des compositions qui contiennent des composés époxy de faible masse moléculaire ou consistent en ceux-ci, en particulier des diluants réactifs.

13. Utilisation de dérivés de l'acide 4-hydroxybutane-1-phosphinique et/ou de son ester intramoléculaire correspondant aux formules suivantes : 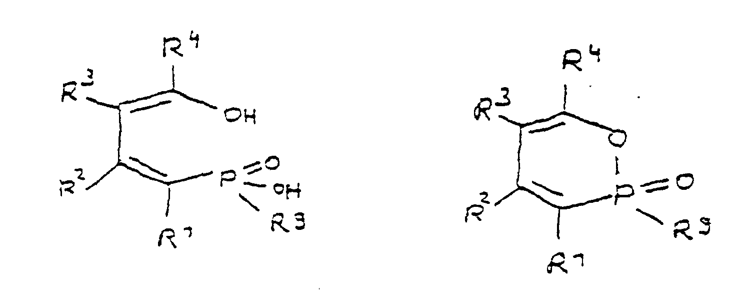 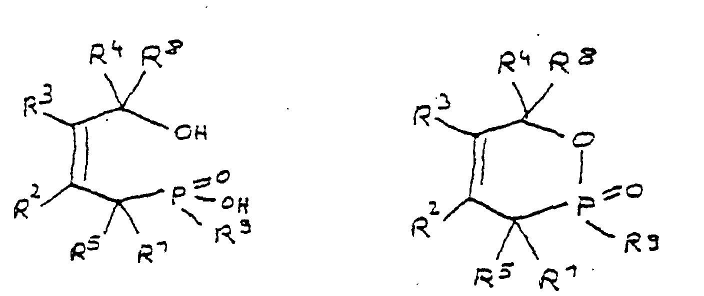 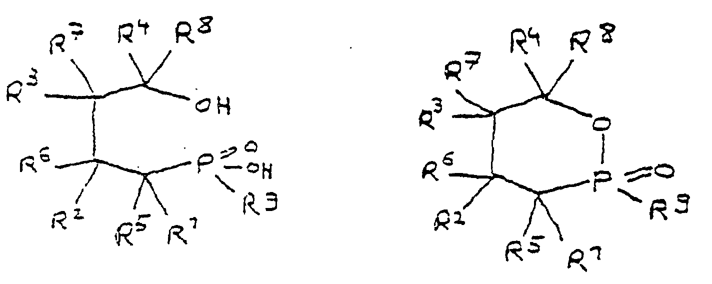 dans lesquelles
R¹ à R⁸ représentent, indépendamment les uns des autres, un atome d'hydrogène ou un groupe hydrocarboné qui contient éventuellement un ou plusieurs hétéroatomes choisis parmi l'oxygène, l'azote, le soufre, le phosphore, le silicium ou un halogène, étant entendu qu'au maximum trois des radicaux R¹ à R⁴ représentent des atomes d'hydrogène, et deux ou plus de deux des radicaux R¹ à R⁸ peuvent être liés avec formation de cycles, et
R9 est un atome d'hydrogène ou
R9 est un groupe qui comporte au moins une fonction époxy, R⁹
(i) étant un groupe hydrocarboné aliphatique, alicyclique ou aromatique qui comporte au moins une fonction époxy, ou
(ii) étant un groupe alkylaryle ou arylalkyle qui comporte au moins une fonction époxy, ou
(iii) étant dérivé de l'adduit de bisphénol A et d'épichlorhydrine et correspondant à la formule 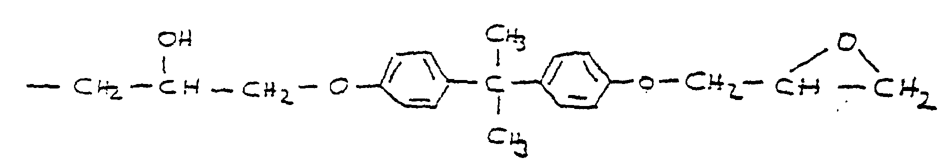 ou
(iv) étant dérivé de l'adduit de bisphénol F et d'épichlorhydrine, ou
(v) étant dérivé de résines époxy à base de Novolaque et/ou de résines époxy à base de Novolaque/crésol, ou
(vi) étant dérivé de diluants réactifs qui contiennent au moins un composé choisi parmi des composés aliphatiques, cycloaliphatiques ou aromatiques à fonction di- à pentaépoxy, ou
(vii) étant dérivé de composés N-glycidyliques à base d'amines ou de polyamines aromatiques ou cycloaliphatiques,
en tant qu'agents ignifuges pour (x) des résines époxy sous forme réticulée, partiellement réticulée ou non réticulée, (y) de produits préparés avec utilisation de résines époxy et (z) de compositions qui contiennent des composés de type résine époxy de faible masse moléculaire ou consistent en ceux-ci, en particulier des diluants réactifs.

14. Utilisation selon la revendication 13, **caractérisée en ce que** le dérivé présente une teneur en phosphore de 2 à 16 % en poids.

15. Utilisation selon la revendication 13 ou 14, **caractérisée en ce que** les radicaux R¹ à R⁸ contiennent ensemble de 6 à 100 atomes de carbone.

16. Utilisation selon la revendication 15, **caractérisée en ce qu'**il s'agit d'un dérivé de l'acide 4-hydroxybutane-1-phosphinique et/ou de son ester intramoléculaire, dans lequel la forme ester correspond à la formule suivante : 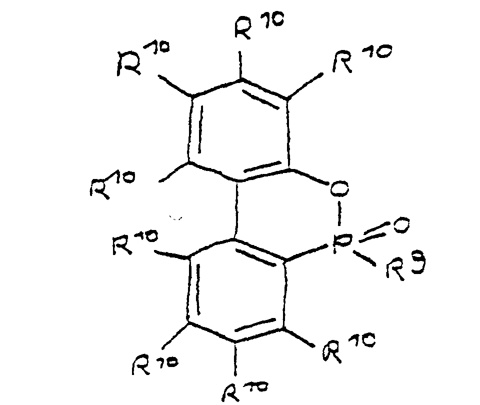 dans laquelle R⁹ a la signification indiquée, et
les radicaux R¹⁰ représentent, indépendamment les uns des autres, un atome d'hydrogène ou d'halogène ou un groupe hydrocarboné qui contient éventuellement un ou plusieurs hétéroatomes choisis parmi l'oxygène, l'azote, le soufre, le phosphore, le silicium et un halogène, deux ou plus de deux des radicaux R¹⁰ pouvant être liés avec formation de cycles.

17. Utilisation selon l'une quelconque des revendications 12 à 16, **caractérisée en ce qu'**on mélange l'agent ignifuge avec la résine époxy non réticulée
ou partiellement réticulée, on y ajoute au moins un durcisseur et, lors du durcissement, la composition ainsi obtenue se transforme en le produit recherché.

18. Résine époxy ignifuge sous forme non réticulée ou partiellement réticulée ou sous forme d'un produit obtenu par réticulation et durcissement, obtenue avec utilisation d'un agent ignifuge selon l'une quelconque des revendications 12 à 17.

19. Résine époxy selon la revendication 18, **caractérisée en ce qu'**elle contient de 2 à 7 % en poids de phosphore dans la masse de la résine, par masse de la résine devant être entendu le poids total de la résine utilisée et de l'agent ignifuge, sans tenir compte d'autres composants tels que durcisseur, charge ou nappe de fibres de verre.

20. Résine époxy selon la revendication 19, **caractérisée en ce qu'**au moins une partie de l'agent ignifuge a réagi avec la résine époxy et/ou le durcisseur éventuellement utilisé, de sorte qu'au moins 50 % de la teneur en phosphore sont liés chimiquement à la résine époxy.

21. Résine époxy ignifuge qui contient de 2 à 7 % en poids de phosphore dans la masse de la résine, par masse de la résine devant être entendu le poids total de la résine utilisée et de l'agent ignifuge, sans tenir compte d'autres composants tels que durcisseur, charge ou nappe de fibres de verre, et qui comporte en tant que partie de sa structure réticulée, partiellement réticulée ou non réticulée, des motifs qui sont issus d'au moins un dérivé de l'acide 4-hydroxybutane-1-phosphinique et/ou de son ester intramoléculaire et sont liés à la résine par leur atome de phosphore, les motifs correspondants aux formules suivantes : 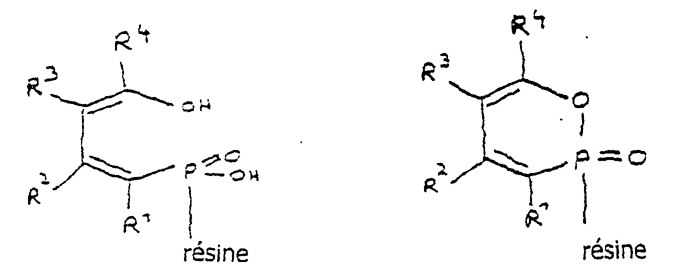 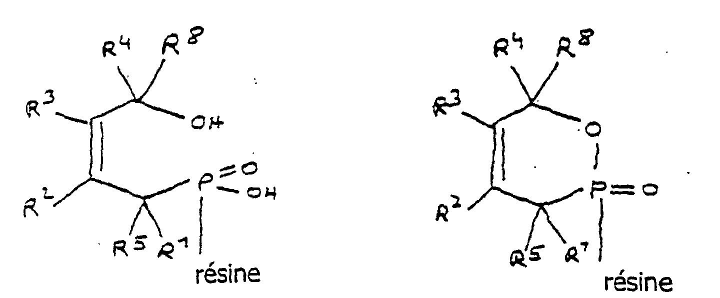 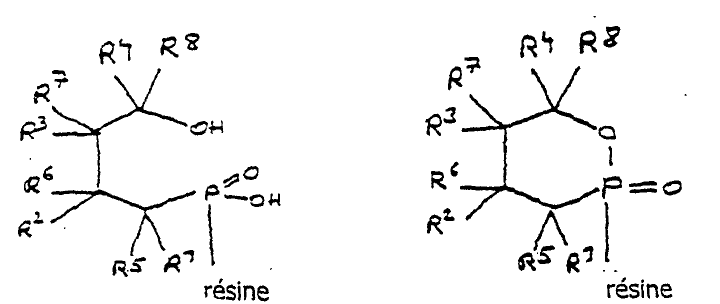 dans lesquelles R¹ à R⁸ représentent, indépendamment les uns des autres, un atome d'hydrogène ou un groupe hydrocarboné qui contient éventuellement un ou plusieurs hétéroatomes choisis parmi l'oxygène, l'azote, le soufre, le phosphore, le silicium ou un halogène, deux ou plus de deux des radicaux R¹ à R⁸ pouvant être liés avec formation de cycles.

22. Résine époxy selon la revendication 21, **caractérisée en ce qu'**au moins trois des radicaux R¹ à R⁴ sont des atomes d'hydrogène.

23. Résine époxy selon la revendication 21 ou 22, **caractérisée en ce que** les radicaux R¹ à R⁸ contiennent ensemble de 6 à 100 atomes de carbone.

24. Résine époxy selon la revendication 23, **caractérisée en ce qu'**elle comporte des motifs qui sont dérivés de l'acide 4-hydroxybutane-1-phosphinique
ou de son ester intramoléculaire, la forme ester des motifs correspondant à la formule suivante : 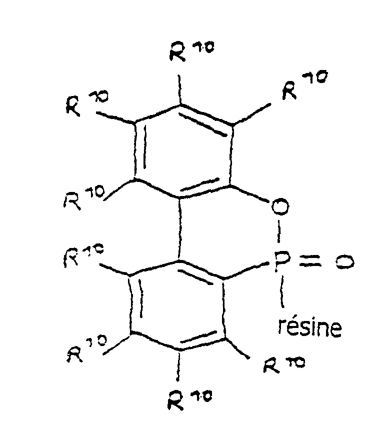 dans laquelle les radicaux R¹⁰ représentent, indépendamment les uns des autres, un atome d'hydrogène ou d'halogène ou un groupe hydrocarboné qui contient éventuellement un ou plusieurs hétéroatomes choisis parmi l'oxygène, l'azote, le soufre, le phosphore, le silicium et un halogène, deux ou plus de deux des radicaux R¹⁰ pouvant être liés avec formation de cycles.

25. Utilisation de la résine époxy selon l'une quelconque des revendications 18 à 24, pour la fabrication de corps moulés ou de revêtements à propriétés ignifuges.

26. Matériaux préimprégnés et composites à base de matériaux de renforcement organiques ou minéraux sous forme de fibres, non-tissés ou tissus ou nappes, fabriqués à partir d'une résine époxy selon l'une quelconque des revendications 18 à 24.

27. Plaquettes pour circuits imprimés à base de préimprégnés, fabriquées à partir de tissu de fibres de verre et de compositions de résine époxy selon l'une quelconque des revendications 18 à 24.

28. Plaquettes pour circuits imprimés selon la revendication 27, **caractérisées en ce que** la composition utilisée comme agent ignifuge est issue d'au moins un dérivé de l'ester intramoléculaire de l'acide 4-hydroxybutane-1-phosphinique.

29. Utilisation selon l'une quelconque des revendications 12 à 17, dans la mise en oeuvre de résines époxy dans le secteur électronique, la composition utilisée comme agent ignifuge étant issue d'au moins un dérivé de l'ester intramoléculaire de l'acide 4-hydroxybutane-1-phosphinique.
